# EUROPEAN PATENT SPECIFICATION

(11) **EP 3 053 168 B1**
(45) Date of publication and mention of the grant of the patent: **30.11.2022**
(21) Application number: 14849641.7
(22) Date of filing: 22.09.2014
(51) Int. Cl.: G11C 16/06, G11C 16/34

(54) **VOLATILE MEMORY ARCHITECTURE IN NON-VOLATILE MEMORY DEVICES AND RELATED CONTROLLERS**
FLÜCHTIGE SPEICHERARCHITEKTUR IN NICHTFLÜCHTIGEN SPEICHERVORRICHTUNGEN UND ZUGEHÖRIGE STEUERUNGEN
ARCHITECTURE DE MÉMOIRE VOLATILE DANS DES DISPOSITIFS À MÉMOIRE NON VOLATILE ET ORGANES DE COMMANDE CORRESPONDANTS

(30) Priority: 30.09.2013 US 201314041334
(43) Date of publication of application: 10.08.2016
(73) Proprietor: Micron Technology, Inc., Boise, ID 83716-9632 (US)
(72) Inventor: CONFALONIERI, Emanuele, Lesmo (Milano), MB 20855 (IT); MINOPOLI, Dionisio, Arzano, NA 80122 (IT)
(74) Representative: Gill Jennings & Every LLP
(86) International application number: PCT/US2014/056840
(87) International publication number: WO 2015/047962

(56) References cited:
- WO-A1-2012/006062
- WO-A2-01/75896
- KR-A- 20120 106 801
- US-A1- 2010 103 723
- US-A1- 2010 110 748
- US-A1- 2011 173 380
- US-A1- 2011 208 905
- US-A1- 2013 028 017
- US-B2- 8 543 787

## Description

### Technical Field

Embodiments of the invention generally relate to electronics, and, in particular, to non-volatile memory devices and/or associated controllers.

### Description of the Related Technology

US 2011/173380A1 discloses a memory system that includes a non-volatile semiconductor memory and a method of controlling the memory system.

Non-volatile memory devices, such as NAND flash memory devices, can be integrated into managed memory devices. An embedded controller of the managed memory device and its associated firmware can translate read and/or programming requests from a host platform into a sequence of commands for the non-volatile memory device based on an established protocol. For instance, an embedded controller can translate requests from a host to commands for a NAND flash memory device in accordance with an Open NAND Flash Interface (ONFI) protocol. Volatile memory, such as static random access memory (SRAM), of controllers of managed memory devices is consuming increasingly more area and making such controllers more expensive.

Embedded multimedia card (eMMC) devices are examples of managed memory devices. Firmware of an eMMC device can translate block write requests into a sequence of read and/or programming commands for a NAND flash memory device. In some instances, the actual programming of the user data can take place by way a of NAND page-programming command. The current definitions of protocols and architectures of registers, such as Data Registers and Cache Registers, of a NAND flash memory device can limit performance of a managed memory device.

Accordingly, a need exists for improving the performance of managed memory devices. A need also exists for reducing the amount of volatile memory of controllers of managed memory devices.

### Summary

According to a first aspect of the invention, there is provided an apparatus as set out in appended claim 1.

According to a second aspect of the invention, there is provided a method as set out in appended claim 9.

### Brief Description of the Drawings

These drawings and the associated description herein are provided to illustrate specific embodiments of the invention and are not intended to be limiting.
Figure 1 is a block diagram of an illustrative NAND flash memory device.
Figure 2 is a diagram of a managed memory device illustrating a conventional manner of programming data to a NAND flash memory array.
Figure 3 is a diagram of a managed memory device illustrating a page programming operation of a NAND flash memory device, according to an embodiment.
Figure 4 is a diagram of a managed memory device illustrating using separate registers of a NAND flash device for read commands and for programming commands, according to an embodiment.
Figure 5 is a diagram of a managed memory device illustrating reading data that is stored in a register and not yet programmed to a NAND flash memory array, according to an embodiment.
Figure 6 is a diagram of a managed memory device illustrating a page programming operation of a NAND flash memory device, according to an embodiment.
Figure 7 is a diagram of a managed memory device illustrating an interleaved read from a NAND flash memory array in which data from a cache register is transferred to a data register, according to an embodiment.
Figure 8 is a block diagram of a managed memory device that includes a plurality of NAND flash memory devices that implement a distributed volatile cache, according to an embodiment.
Figure 9 is a diagram of an illustrative NAND flash memory device according to another embodiment.
Figures 10A and 10B are diagrams illustrating embodiments of swapping data between registers of a multi-plane NAND flash memory device.
Figures 11A, 11B, and 11C are diagrams that illustrate a process of temporarily loading first data in a register with an interleaved cache read operation to read second data according to an embodiment.
Figures 12A, 12B, and 12C are diagrams that illustrate a process of temporarily loading first data in a register with an interleaved cache programming operation to program second data to the array according to an embodiment.

To avoid repetition of description, components having the same or similar function may be referenced by the same reference number.

### Detailed Description of Certain Embodiments

Although particular embodiments are described herein, other embodiments, including embodiments that do not provide all of the benefits and features set forth herein, will be apparent to those of ordinary skill in the art.

As discussed above, current definitions of the protocols and/or architectures of registers, such as data registers and cache registers, of a NAND flash memory device can limit performance of a managed memory device. For example, specifying that data registers and cache registers are used in both read commands and write commands of the NAND flash memory can limit performance of the managed memory device. Performance can be limited by random programming operations, which can also be referred to as random write operations.

One way of addressing random programming performance in a managed memory device is to implement a volatile cache in a solid state disk (SSD) or an eMMC device. With a volatile cache, relatively fast programming operations can be performed. Such performance can improve input/output operations per second (IOPS) of a NAND flash memory and/or other non-volatile memories. At the same time, the volatile cache can significantly increase the size of a controller. The increased size of the controller can lead to higher costs.

Generally described, aspects of this disclosure relate to achieving a relatively good random programming performance for a non-volatile memory device while using a relatively limited amount of volatile memory on a controller associated with the non-volatile memory. A register architecture of a NAND flash memory device is described herein. Separate registers can be used for read operations and programming operations. As such, one register of the NAND flash memory device can be used for programming operations and another register of the NAND flash memory device can be concurrently used for read operations, according to certain embodiments. For example, cache registers can be used for read operations and data registers can be used for programming operations. Some register architectures described herein can enable swapping of data between registers. Accordingly, first data to be programmed to the memory array can be loaded into a register and interleaved read and/or interleaved programming operations can be executed while preserving the first data loaded into the register. For instance, first data to be programmed to the memory array can be swapped between a cache register and a data register to enable one or more other read and/or programming operations to be performed while preserving the first data. As another example, first data to be programmed to the memory array can be moved from a cache register to a virtual cache register, which is separate from the data and cache registers, while one or more read and/or programming operations are executed. Then the first data to be programmed to the memory array can be moved back to the cache register from the virtual cache register. Registers of NAND flash memory devices can implement a distributed virtual cache within a managed memory device, in certain embodiments. This can boost performance of random programming operations with little or no impact on performance of random read operations. In some embodiments, one or more data registers can implement the distributed virtual cache. Although some examples are described herein with reference to NAND flash memory devices for illustrative purposes, it will be understood that the principles and advantages described herein can be implemented in connection with any suitable non-volatile memory device. For instance, the principles and advantages described herein can be implemented in connection with phase change memory (PCM).

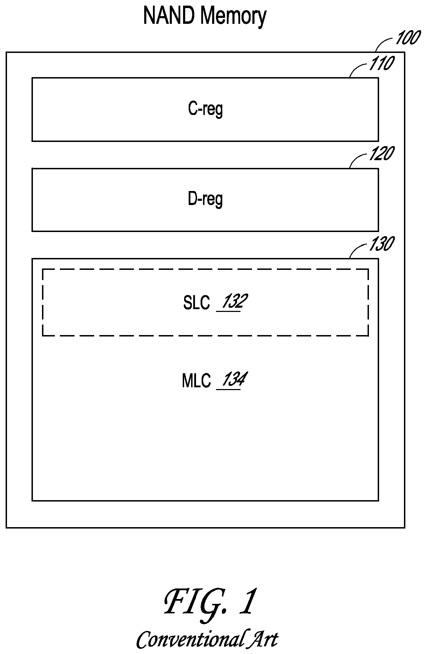

Figure 1 is a block diagram of an illustrative NAND flash memory device 100. As illustrated, the NAND flash memory device 100 includes a cache register 110, a data register 120, and an array of non-volatile memory 130. Any of the registers described herein can be referred to as page buffers or latches according to certain implementations. The data register 120 can also be referred to as a page register. The cache register 110 and the data register 120 can each comprise volatile memory. During a write operation, data from a host is loaded in the cache register 110. The cache register 110 and the data register 120 can be used to hold data before data is programmed to a page of the array 130 and/or after data is retrieved from the array 130. Typically, data to be programmed is clocked into the cache register 110 in a serial manner. The data to be programmed is then moved from the cache register 110 to the data register 120, typically in a parallel manner. This frees up the cache register 110 to receive data for the programming or for the reading of other pages. Data to be read is retrieved from the array 130 and loaded in the data register 120. The data is then moved from the data register 120 to the cache register 110, from which the data is clocked out to the host. The cache register 110 and/or the data register 120 can hold at least a page of data. The array 130 can include single level cells 132 and multi-level cells 134. The single level cells 132 are configured to store one digit of information, such as a bit of information. The multilevel cells 134 are configured to store more than one digit of information, such as multiple bits of information.

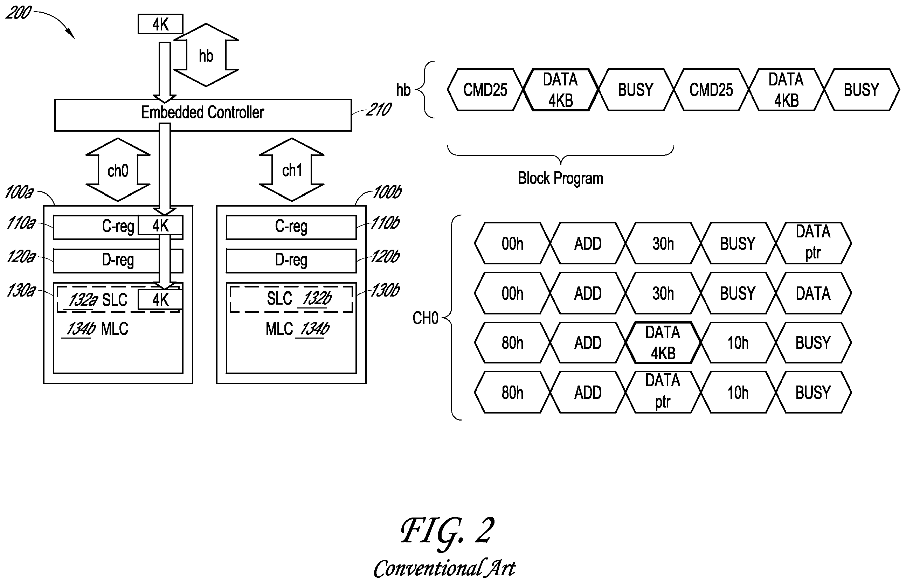

Figure 2 is a diagram of a managed memory device 200 illustrating a conventional manner of programming data to a NAND flash memory array. The managed memory device 200 can include a controller 210 and a plurality of NAND flash memory devices 100 in communication with the controller 210 via channels CH0 and CH1. As illustrated, the plurality of NAND flash memory devices 100 includes a first NAND flash memory device 100a and a second NAND flash memory device 100b. The managed memory device 200 can be an eMMC device or a SSD, for example. The first NAND flash memory device 100a and the second NAND flash memory device 100b can be implemented by different dies that are connected to the controller 210 through two channels CH0 and CHI, respectively. The first NAND flash memory device 100a and the second NAND flash memory device 100b can be substantially the same as each other except for external connections.

The controller 210 can be an embedded controller. The controller 210 can receive data from a host via a host bus HB. The controller 210 can receive requests to access the first NAND flash memory device 100a and/or the second NAND flash memory device 100b via the host bus HB. The controller 210 can also receive segments of user data via the host bus HB. Mass storage devices, such as solid-state drives and flash drives, can transfer data in units of data called "blocks." The segments of user data received by the controller 210 are different than blocks that describe the minimum erasable unit of memory in a flash memory. User data can be sent in segments from the host to the controller 210. A page of a flash memory array 130a and/or 130b comprises a plurality of segments. As one non-limiting example, a segment of user data can be 4 kilobytes (KB) of data as illustrated in Figure 2. Other sizes of segments will also be applicable. In the example shown in Figure 2, the controller 210 can receive a request CMD25 to access the first NAND flash memory device 100a, then a segment of user data DATA 4KB, and then a busy request BUSY.

The controller 210 can translate the requests into commands for the first NAND flash memory device 100a. Example commands generated by the controller 210 for a block write operation in a page program operation on one NAND flash memory device based on the requests received from the host are shown in Figure 2. These commands can be provided to the first NAND flash memory device 100a via a channel CH0 between the controller 210 and the first NAND flash memory device 100a.

The commands received by the first NAND flash memory device 100a cause the segment of user data to be loaded in the cache register 110a and then cause the segment of user data to be programmed to the array 130a of non-volatile memory. Accordingly, the first NAND flash memory device 100a programs one segment of data to the array 130a at a time. A plurality of programming operations each associated with one or more segments of data can program a page of user data to the array 130a.

In NAND flash memory devices 100 operating in accordance with current ONFI standards, cache registers 110 and/or data registers 120 are used during commands associated with page-read, page-cache-read, page-program, and page-cache-programming operations. For example, a page-program operation (80h-10h) enables the host to load data to a cache register 110 and then program the contents of the cache register 110 to a specified block and page address in the array 130 of the flash memory. As another example, a page-cache-program operation (80h-15h) enables the host to load data to the cache register 110, move the received data from the cache register 110 to the data register 120, and then program the contents of the data register 120 to the specified block and page address in the array 130 of the NAND flash memory while the cache register 110 is available for one or more additional page-cache-program operations (80h-15h) and/or page-program operations (80h-10h). Thus, in some operations such as a page-cache-program operation (and a page-cache read operation) both the cache register 110 and the data register 120 are used and in some other operations such as the page-program (and a page-read) operation only one register of these registers is used.

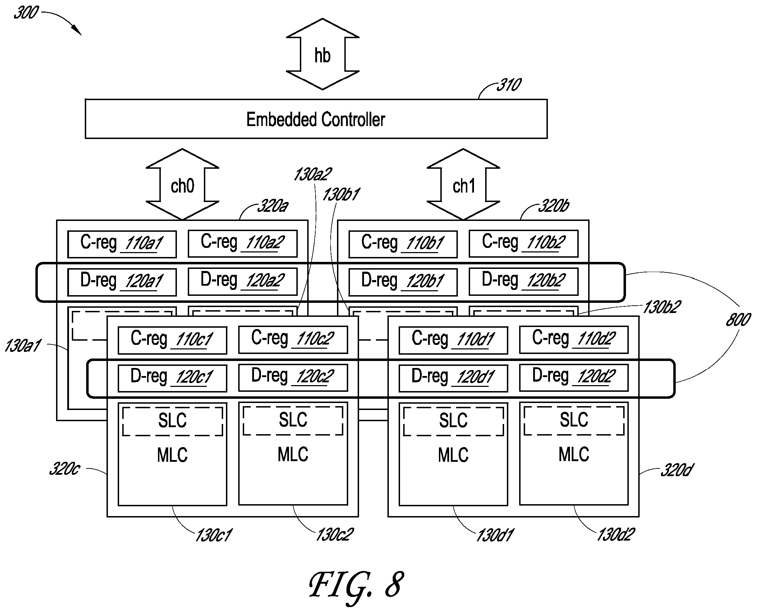

In the case of random block programs from the host, the performance of the managed memory can be driven by the NAND page program time. However, the page size in the NAND memory array is typically greater than the size of segments of user data provided by the host to a controller 210 via a host bus HB. NAND pages size have been increasing over time. To improve random program performance, an embedded SRAM can be included in some embedded controllers and used as a buffer for programming operations. This SRAM can be used to build a page or page stripe aggregating a number of program requests associated with one or more segments of data. A page stripe can correspond to a page of data when there is one plane of non-volatile memory. When there are multiple planes of non-volatile memory, a page stripe can correspond to a full page in each of the multiple plans. For instance, a page stripe in each NAND flash memory device 320a-320d of Figure 8 includes two pages. Any of the principles and advantages discussed herein with reference to a page can be applied to a page stripe when a page stripe corresponds to multiple pages. Accordingly, when a full page or page stripe of data to be programmed to the array is ready, it can be transferred from the SRAM to the registers of the NAND flash memory.

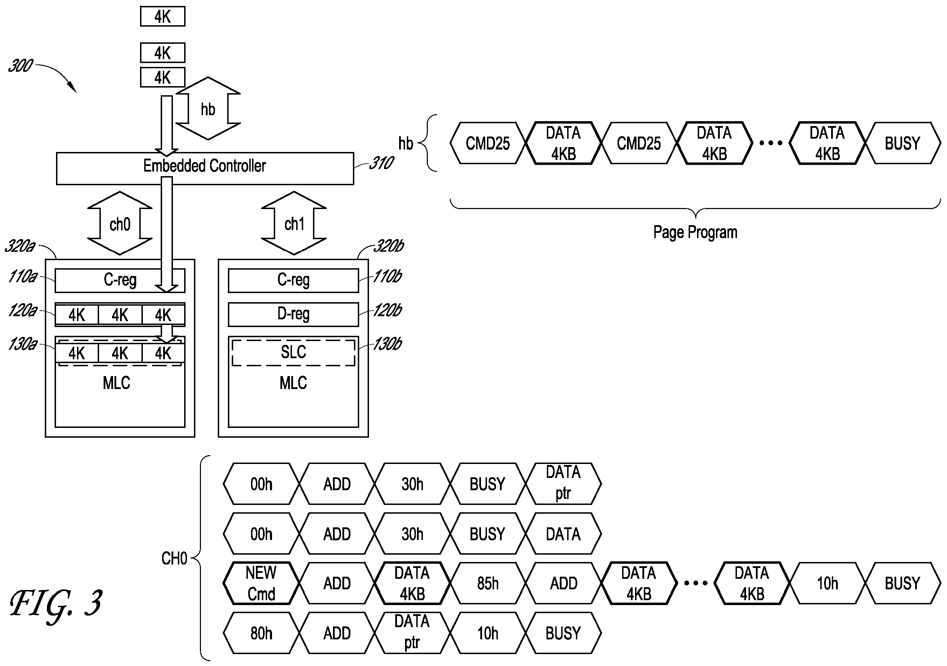

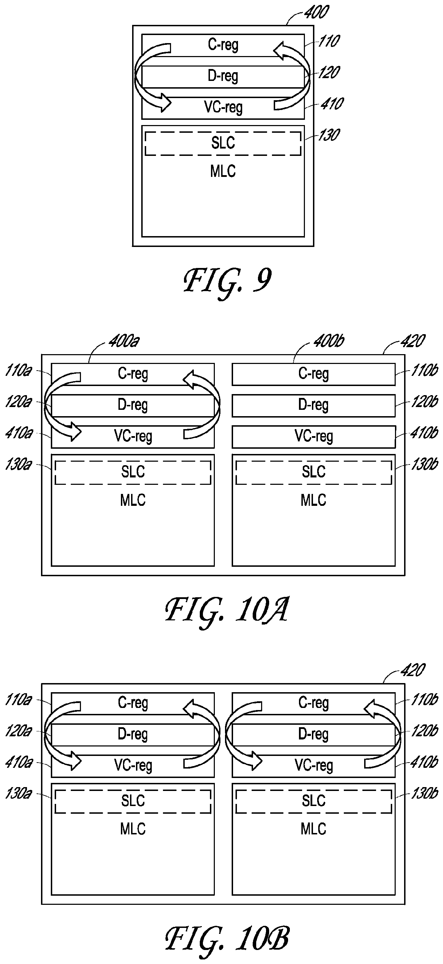

Random program performance of a managed memory device can be improved by the register architecture and/or the translation of host requests into commands for a non-volatile memory disclosed herein. Managed memory devices 300 of Figures 3 to 8 include a controller 310 that can translate host requests into new commands for non-volatile memories. The controller 310 can also translate host requests into new commands for any of the memories of Figures 9 to 12C. The controller 310 can be an embedded controller as illustrated. The controller 310 can translate host commands using hardware, firmware, or any combination thereof. These managed memory devices 300 can include NAND flash memory devices 320a and 320b that can implement new functionalities associated with the new commands. To implement the new commands, the NAND flash memory devices 320a and 320b can include different physical hardware compared to the NAND flash memory devices 100a and 100b that are configured to implement conventional commands. For example, the NAND flash memory devices 320a and 320b can include a decoder configured to decode the new commands when the new commands are received from the controller 310. As another example, the NAND flash memory devices 320a and 320b can include different connections to the cache register 110 and/or the data register 120 compared to the NAND flash memory devices 100a and 100b that are configured to implement conventional commands. Circuitry to support the new commands can also be included in the NAND flash memory devices 320a and 320b. The internal functionality of the cache register 110, the data register 120, and/or the array 130 in NAND flash memory devices 320a and 320b can be substantially the same as the NAND flash memory devices 100a and 100b, respectively.

In some embodiments, a register of a non-volatile memory can be used for read operations and a different register of the non-volatile memory can be used for write operations. For instance, cache registers of a NAND flash memory can be used in connection with read operations and data registers of the NAND flash memory can be used in connection with programming operations. Data registers of a plurality of NAND flash memory devices can together implement a distributed virtual cache (DVC) architecture in the managed memory device, according to some embodiments. The DVC can receive data from inputs of a NAND flash memory device without interfering with data read from an array of NAND flash memory cells stored in a register of the NAND flash memory device. The DVC can store segments of user data on NAND flash memory device(s) as they are being aggregated into a page of data to be programmed to NAND flash memory cells. For example, segments of user data can be stored by volatile memory of a plurality of different non-volatile memory devices when the user data is associated with different pages of data. The segments of user data can be accessed by a controller external to the non-volatile memory even when the user data is not stored in the array of non-volatile memory cells. The DVC can reduce the need for RAM or other volatile memory in the controller.

Figure 3 is a diagram of a managed memory device 300 illustrating a page programming operation of a NAND flash memory device 320a, according to an embodiment. In the managed memory devices 300, a number of programming commands CMD25 associated with a single segment of data received from a host can be translated by the controller 310 to a single page program operation on a NAND flash memory 100a and other associated management operations, for example, as shown in Figure 3. The number of programming commands CMD25 to be aggregated by the controller 310 into a single page program operation can be based on physical characteristic(s) of the NAND flash memories, such as page sizes and/or number of planes, and the number of channels of NAND flash memories. In an illustrative example, with a 12 KB page size, 3 program commands CMD25 each associated with a single 4 KB segment of data can be aggregated into one page program operation by the controller 310. The firmware of an embedded controller 310 can perform such aggregation in certain embodiments. Hardware of the embedded controller 310 can perform such aggregation in some other embodiments.

The controller 310 can provide the NAND flash memory device 320a with a new page program through data register NEW Cmd command in connection with aggregating programming commands CMD25 from the host into a single page program operation in the NAND flash memory device 320a. The page program through data register command NEW Cmd can enable the controller 310 to load data to the data register 120a, and program the data from the data register 120a to a specified address in the array 130a of the NAND flash memory device 320a without interfering with the data held in the cache register 110a. The NAND flash memory device 320a can have circuitry configured to provide user data to the data register 120a without loading the user data to the cache register 110a, unlike the NAND flash memory device 100 (Figure 2). As shown in Figure 3, the page program through data register command NEW Cmd and other associated commands can cause the NAND flash memory device 320a to incrementally load user data received from the controller 310 via the channel CH0 into the data register 120a segment by segment. Then when a full page of user data is loaded in the data register 120a, the page of user data can be programmed to the array 130a via a single page program operation.

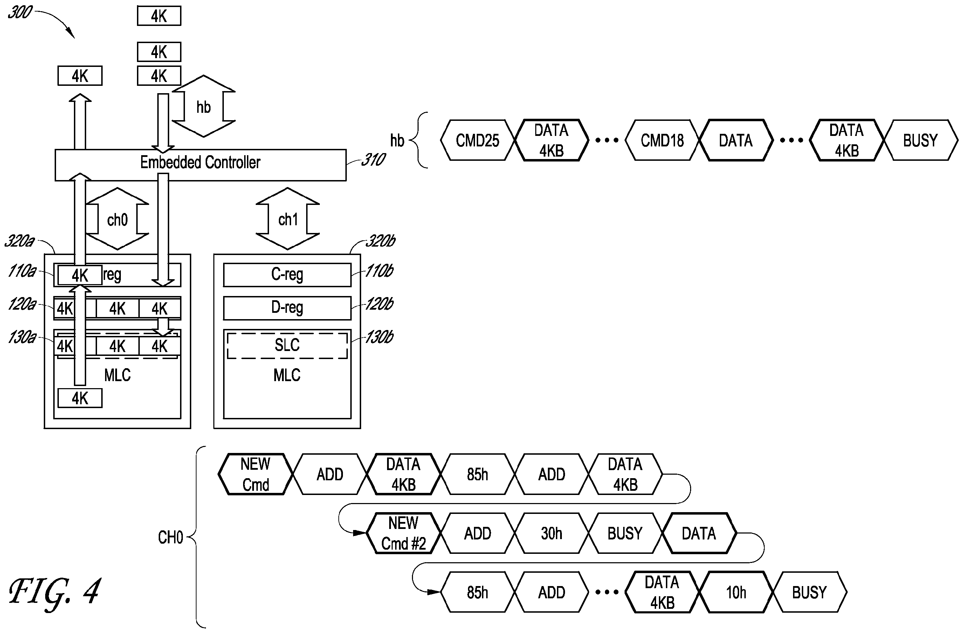

Figure 4 is a diagram of a managed memory device 300 illustrating using separate registers of a NAND flash device for read commands and for programming commands, according to an embodiment. Using separate registers for read commands and for programming commands can avoid conflicts in register usage. For example, read commands received from the host can be served without destroying the segments of user data being aggregated into a page of user data in a register of the NAND flash memory device 320a, such as the data register 120a as illustrated in Figure 4. Using separate register can also enable data to be programmed to the array 130 be loaded in a first register without using a second register, and then loading read from the array 130. Then data from the second register can be provided to the controller 130 while the first register is holding the data to be programmed to the array 130. Read operations associated with one or more segments on the host side can be translated by the controller 310 into a page read operation for the NAND flash memory device 320a. The page read operation can use the cache register 110a of the NAND flash memory device 320a.

In the NAND flash memory device 320a, the cache register 110a can be connected to read circuitry associated with the array 130 and the data register 120a can be connected to write circuitry associated with the array 130. Accordingly, data to be programmed to the array 130a and data read from the array 130a can propagate on separate signal lines connected to the different registers. In the NAND flash memory device 320a, the cache register 110a can be connected to read circuitry associated with the array 130 and the data register 120a can be connected to write circuitry associated with the array 130.

For instance, first array signal lines can electrically connect the array 130a and the data register 120a and second array signal lines can electrically connect the array 130a and the cache register 110a. The data register 120a can receive user data received from the controller 310 at inputs of the NAND flash memory device 320a without the user data being provided to the cache register 110a. The NAND flash memory device 320a can include different electrical connections between the input/output contacts and the cache register 110a and the data register 120a.

The managed memory device 300 of Figure 4 can support a read while loading mechanism in the NAND flash memory device 320a. The controller 310 can translate requests to read and program the NAND flash memory device 320a into a page program through data register command NEW Cmd and a page read through cache register command NEW Cmd #2. The page program through data register command NEW Cmd and the page read through cache register command NEW Cmd #2 can be provided to the NAND flash memory device 320a via the channel CH0. The page read through cache register command NEW Cmd #2 can retrieve a segment of data from the array 130a and store the segment of data to the cache register 110a. This can enable the NAND flash memory device 320a to retrieve data from the array 130a without interfering with the data stored in the data register 120a. Accordingly, while a page of data is being aggregated in the data register 120a, data can be read from the array 130a and provided to the controller 310 without destroying a page or page stripe under construction in the data register 120a. In another embodiment (not illustrated), the page read through cache register command NEW Cmd #2 can retrieve two or more segments of data (for example, a page of data) from the array 130a and load the two or more segments of data to the cache register 110a.

Using separate registers for read and programming operations can enable both of the separate registers to be concurrently used for a command associated with a read operation and a command associated with a programming operation. For example, as shown in Figure 4, a programming command can enable the controller 310 to load data to a data register 120a via channel CH0, and program the data from the data register 120a to the specified address in the array 130a of the NAND flash memory device 320a. As also shown in Figure 4, a read command can retrieve data from a page of an array 130a of the NAND flash memory device 320a and load the retrieved data to a cache register 110a while the data register 120a is holds data for programming to the array 130a. The retrieved data can be provided from the cache register 110a external to the NAND flash memory device 320a.

The managed memory device 300 can support a load while read mechanism in the NAND flash memory device 320a. While the managed memory device 300 is performing a read operation, data to be programmed to an array 130a of the NAND flash memory device 320a can be loaded into a register of the NAND flash memory device. For instance, the operations described with reference to Figure 3 can be performed while data retrieved from the array 130a is held in the cache register 110a in connection with a read operation.

The controller 310 can track a position of data to be programmed to the array 130a as the data is being held by the cache register 110a or the data register 120a so that the controller 310 can properly move the data to complete an operation to program the data to the array 130a and/or return the data held in the cache register 110a or the data register 120a to the host when such data is not yet programmed to the array 130a. Additionally, the controller 310 can receive an indication of the data being programmed to the array 130a to track the position of the data. One or more registers and/or firmware of the controller 310 can store tracking information to track the position of data on the NAND flash memory device 320a.

In some cases, the host may send a request to read back data that have been recently provided to the NAND flash memory device 320a for programming. When the request is received from the host, the data associated with the request may still be held in a register of the NAND flash memory device 320a and may not yet be programmed to the array 130a. The controller 310 can support reading the data from the register of the NAND flash memory device 320a by translating requests received by the host into a command to read data from the register that holds the requested data instead.

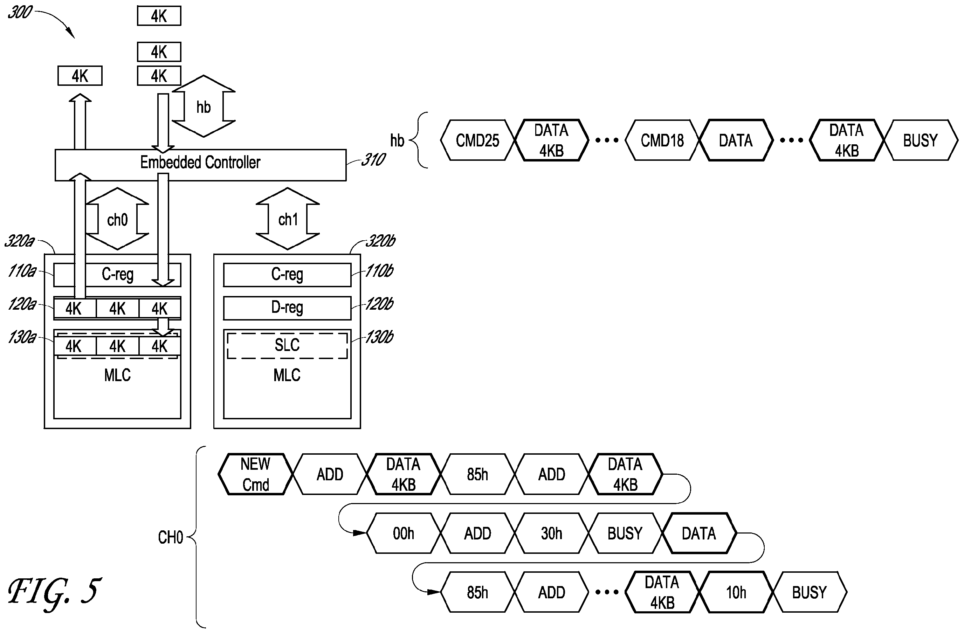

Figure 5 is a diagram of a managed memory device 300 illustrating reading data that is held in a data register 120a and not yet programmed to a NAND flash memory array 130a, according to an embodiment. As shown in Figure 5, the controller 310 can provide the NAND flash memory device 320a with a page program through data register command NEW Cmd. The controller 310 can determine whether there is data held in the data register 120a and not yet programmed to the NAND flash memory array 130a. For instance, the controller 310 can check if the data requested corresponds to data held in data register 120a by checking the tracking information stored by the controller 310. While segments of user data are being aggregated into a page of data in the data register 120a, the controller can translate a request to read data from the NAND flash memory device 320a into a command DATA that returns the requested segment of data from the data register 120a. Accordingly, data held in the volatile memory of the NAND flash memory device 320a can be retrieved when the data is not stored in the array 130a. The NAND flash memory device 320a can continue aggregating segments of user data until a page of data is stored in the data register 120a. Then the page of data can be programmed to the array 130a during a page program operation that completes with command 10h.

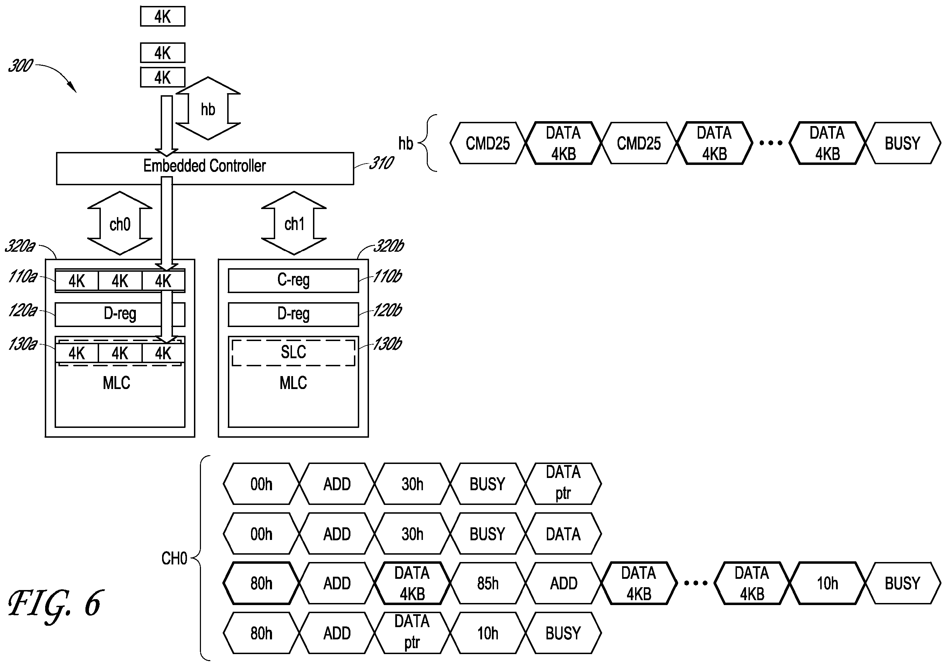

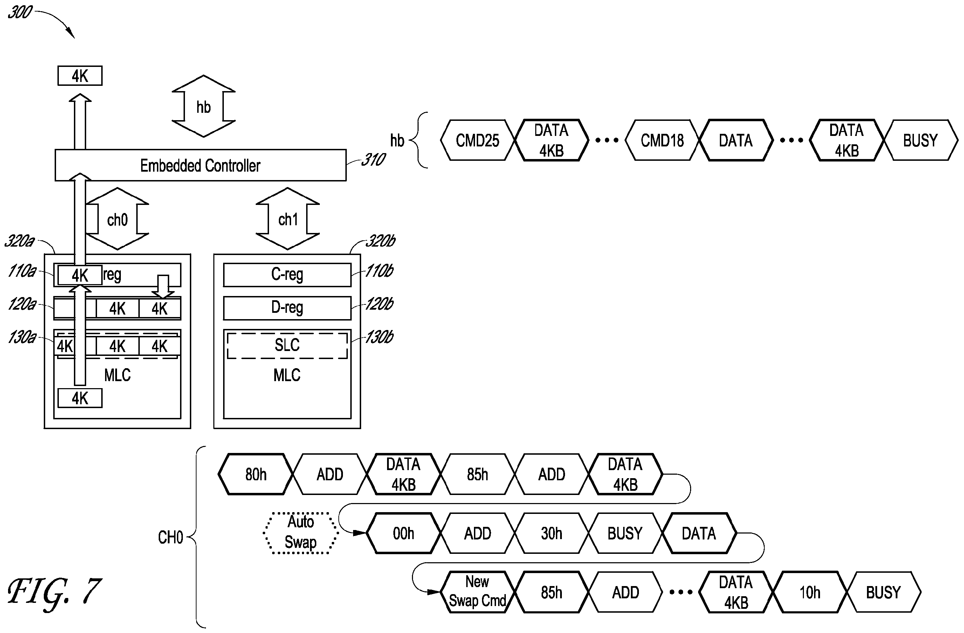

In certain implementations, the cache register 110a can be used for both read operations of the NAND flash memory device 320a and for programming operations of the NAND flash memory device 320a. In such implementations, a dedicated command can be used to swap data between the cache register 110a and the data register 120a to implement features of a distributed virtual cache. Figures 6 and 7 relate to embodiments in which the cache register 110a is used for both read and programming operations of the NAND flash memory device 320a.

Figure 6 is a diagram of a managed memory device 300 illustrating a page programming operation of a NAND flash memory device 320a, according to an embodiment. In contrast to the embodiment of Figure 2, an entire page of user data can be loaded into the cache register 110a one segment at a time and then the entire page can be programmed to the array 130a. The embodiment of Figure 6 is like the embodiment of Figure 3 except that user data is loaded into the cache register 110a instead of the data register 120a. Accordingly, the embodiment of Figure 6 can use separate registers for read operations and programming operations. In particular, the cache register 110a can be used for read operations and the data register 120a can be used for programming operations. Loading user data to the cache register 110a instead of the data register 120a may result in fewer changes to some existing methods of programming data to an array 130a of the NAND flash memory, such as using the existing ONFI standard.

Figure 7 is a diagram of a managed memory device 300 illustrating an interleaved read from an array 130a in which data from a cache register 110a is transferred to a data register 120a, according to an embodiment. The principles and advantages associated with swapping data between the cache register 110a and the data register 120a can be implemented in connection with first data associated with any suitable read and/or program operation in which first data is loaded into the cache register 110a and there is a need to preserve the first data during another operation.

Before translating a request to retrieve data from the array 130a, the controller 310 can determine whether there is data held in the cache register 110a and not yet programmed to the array 130a. For instance, the controller 310 can check if the data requested corresponds to data held in cache register 110a based on the tracking information stored by the controller 310. When there is less than a page of data held by the cache register 110a to be programmed to the NAND flash memory array 130a, the controller can cause the NAND flash memory device 320a to move the data held by the cache register 110a to free the cache register 110a for a read operation in a manner that does not lose the data. The controller 310 can translate host requests into a swap command New Swap Cmd to move data from the cache register 110a to the data register 120a. According to the invention, this maintains data in a distributed virtual cache implemented by data registers 120a and 120b of the NAND flash memory devices 320a and 320b. For instance, when user data is being aggregated in the cache register 110a and less than a page of user data is held by the cache register 110a, the user data can be moved to the data register 120a. Then the user data can be moved back to the cache register 110a after the retrieved data is provided to an output of the NAND flash memory device 320a.

Figure 7 illustrates an interleaved read in which data in the cache register 110a is moved to the data register 120a. In one embodiment, the NAND flash memory device 320a can load first data into the cache register 110a one segment at a time. A request to read second data from the array 130a can be received from the host while the cache register 110a holds the first data. The first data can comprise less than a full page of data. The second data can comprise one or more segments of data stored in the array 130a. In some instances, the second data comprises a page of data. The first data held by the cache register 110a can be moved to the data register 120a. Then the second data can be retrieved from the array 130a and loaded in the cache register 110a while the data register 120a holds the first data. The second data can then be provided to an output of the NAND flash memory device 320a. While the data register 120a holds the first data, additional data can retrieved from the array 130 and loaded into the cache register 110a and output from the NAND flash memory device 320a. While the data register 120a holds the first data, programming operations such as a page-cache-program operation can be performed as an alternative to an interleaved read operation or in addition to an interleaved read operation. In such programming operations, data can be loaded into the cache register 110a and then programmed to the array 130 while the data register 120a hold the first data. When the reading and/or writing operations are completed, the first data can be moved from the data register 120a to the cache register 110a. The first data can subsequently be programmed to the array 130. For instance, once a full page of data is held by the cache register 110a, the contents of the cache register 110a can be programmed to the array 130a.

Figure 8 is a block diagram of a managed memory device 300 that includes a plurality of NAND flash memory devices 320a, 320b, 320c, and 320d that implement a distributed virtual cache (DVC) 800, according to an embodiment. The principles and advantages described herein can be applied to managed memory devices 300 that include more than two NAND flash memory devices and/or to NAND flash memory devices that include two or more planes of registers and arrays. The data registers 120a1-120d2 of multiple NAND flash memory devices 320a-320d together implement the DVC 800. The DVC 800 can use registers of NAND flash memory devices 320a-320d that comprise volatile memory to temporarily hold data on the NAND flash memory devices 320a-320d. Such a DVC 800 can be implemented, for example, in embedded multi-media card applications. The DVC 800 can enable data to be held by registers on the NAND flash memory devices 320a-320d when aggregating user data from multiple programming requests from a host into a page program operation, for example. For example, moving data from the cache register 110 to the data register 120 as described with reference to Figure 7 can implement features of the DVC 800. In some embodiments, the NAND flash memory devices 320a, 320b, 320c, and 320d can selectively enable and/or disable a DVC mode. For instance, a trim setting can selectively enable and/or disable the DVC mode.

The DVC 800 can boost random program performance of a managed memory device 300 without increasing the amount of volatile memory on the controller 310. Alternatively, the DVC 800 can achieve substantially the same random program performance with less volatile memory on the controller 310. Thus, the DVC 800 can improve random write performance in a managed memory device and/or reduce the cost of a controller in the managed memory device.

The DVC 800 can result in performance benefits of an increase in read/program IOPS of close to the number of segments of data that can be stored by the DVC 800. For example, when the DVC 800 is made up of four dies each having two data registers each configured to store a page of 16 KB of data, and data segments are sent to the dies in 4 KB segments, the DVC 800 can store 4 x 2 x 16KB = 128 KB of data. Since each segment is 4 KB of data in this example, close to a 32 times increase in random program IOPS can be achieved. In another example, when the DVC 800 is made up of one die having two data registers each configured to store a page of 16 KB of data, and data segments are sent to the dies in 4 KB segments, close to an 8 times increase in random program IOPS can be achieved.

The DVC 800 can be implemented in accordance with any suitable combination of features described herein. In certain implementations, the DVC 800 can be implemented in accordance with the embodiments of Figures 3-5. According to some other implementations, the DVC 800 can be implemented in accordance with the embodiments of Figures 6-7. Although the illustrated DVC 800 comprises data registers 120a-120d, it will be understood that cache registers 110a-110d and/or other volatile memory on a non-volatile memory device can implement a DVC in some other embodiments. For instance, separate virtual cache registers 410a and 410b can implement a DVC in the embodiments of Figures 10A and 10B.

The register architecture described herein can be compatible with garbage collection and wear leveling functionalities of a managed memory device 300. The firmware and/or hardware of the controller 310 can execute garbage collection and/or wear leveling. In certain embodiments, garbage collection and wear leveling can be kept on hold until the completion of a programming operation. Alternatively or additionally, the programming operation may be forced before completely filling a register, such as the data register, with a full page of data.

The register architecture for NAND flash memory devices in the current ONFI standard does not enable a page cache read operation to be performed while first data to be programmed to a memory array is being loaded into a register of a NAND flash memory device segment by segment without losing the first data. Yet page cache read operations can be used to boost sequential read performance to meet current and future managed memory standards. Additionally, the current ONFI standard does not enable a page program operation or a page cache program operation to be performed while first data to be programmed to a memory array is being loaded into a register of a NAND flash memory device segment by segment without losing the first data. However, page program and page cache program operations with different data can aid firmware (and/or hardware) of a managed memory in updating a logical to physical pointers table and/or during garbage collection activities, for example. Accordingly, a need exists for improving performance in NAND flash memory devices.

The embodiments illustrated in Figures 9 to 12C are examples of a register architecture of a NAND flash memory device that can temporality load first data into a register and perform an interleaved page cache read operation, page read operation, or page cache program operation associated with second data while preserving the first data. This new register architecture includes three separate registers on an NAND flash memory device. In addition, the NAND flash memory device can execute new move and/or swap commands to move data from the cache register 110 to/from the virtual cache register 410. The NAND flash memory devices 400, 400a, and/or 400b of Figures 9 to 12C can be implemented in place of any of the NAND devices 320a-320d of Figures 3 to 8 in any of the managed memory devices 300 of Figures 3 to 8. The controller 310 of such a managed memory device 300 can generate the new move and/or swap commands to move data from the cache register 110 to/from the virtual cache register 410.

Figure 9 is a diagram of an illustrative NAND flash memory device 400 according to an embodiment. The NAND flash memory device 400 can implement any combination of features of the NAND flash memory devices 320a-320d. The NAND flash memory device 400 can also implement additional moving and/or swapping features with an additional register to implement a virtual cache. The NAND flash memory device 400 can be implemented with a controller 310 in a managed memory device 300.

The illustrated NAND flash memory device 400 includes a cache register 110, a data register 120, a virtual cache register 410, and an array 130. The cache register 110 and the data register 120 can execute the operations defined by the current ONFI standard. The virtual cache register 410 can hold the same amount of data as the cache register 110 and the same amount of data as the data register 120 in one embodiment. Accordingly, the virtual cache register 410 can hold a page of data. In some other embodiments, the virtual cache register 410 is full when it holds less than a page of data. For example, in some implementations, the virtual cache register 410 is sized to hold one segment less than a full page of data. The virtual cache register 410 can hold data previously loaded in the cache register 110 while the cache register 110 is used to execute other operations. Accordingly, the virtual cache register 410 can hold data previously loaded into the cache register 110 during any operation that uses both the cache register 110 and the data register 120 to access the array 130. For instance, the virtual cache register 410 can hold data previously stored in the cache register 110 during a page read operation, page cache read operation, a page cache program operation, or any combination thereof.

While the virtual cache register 410 holds first data, second data can be transferred between the cache register 110 and the array 130 via the data register 120. For instance, the second data from the array 130 can be loaded to the data register 120. Then the second data can be moved from the data register 120 to the cache register 110. The second data can be output from the cache register 110 to an output of the NAND flash memory device 400. As another example, the second data can be loaded into the cache register 110 and moved to the data register 120. Then the second data can be provided to the array 130 from the data register 120 and programmed to the array 130.

A controller 310 can generate a new Move to VCache command to move data from the cache register 110 to the virtual cache register 410. The controller 310 can also generate a new Move from VCache command to move data from the virtual cache register 410 to the cache register 110. Alternatively, the controller 310 can generate a new VCache Swap command to swap the contents of the cache register 110 with the virtual cache register 410.

Figures 10A and 10B are diagrams illustrating embodiments of swapping data between registers of a multi-plane NAND flash memory device 420. As shown in Figure 10A, data can be moved between the cache register 110a and the virtual cache register 410a in a selected plane 400a of the multi-plane NAND flash memory device 420 by executing a single plane command. Single plane swap and/or move commands can only operate on the selected plane while data in the other planes is not swapped and/or moved between the cache register 110b and the virtual cache register 410b of the unselected plane(s). Alternatively or additionally, as shown in Figure 10B, data can be moved between the cache registers 110a and 110b to the virtual cache registers 410a and 410b in a multiple planes 400a and 400b of the multi-plane NAND flash memory device 420 by executing a multi-plane command. Multi-plane swap and/or move commands can operate on all addressed planes simultaneously. A NAND flash memory device 420 can implement single-plane and/or multi-plane swap and/or move commands. While the multi-plane NAND flash memory device 420 is illustrated as having 2 planes in Figures 10A and 10B, the principles and advantages described herein can be applied to implementations with more than 2 planes.

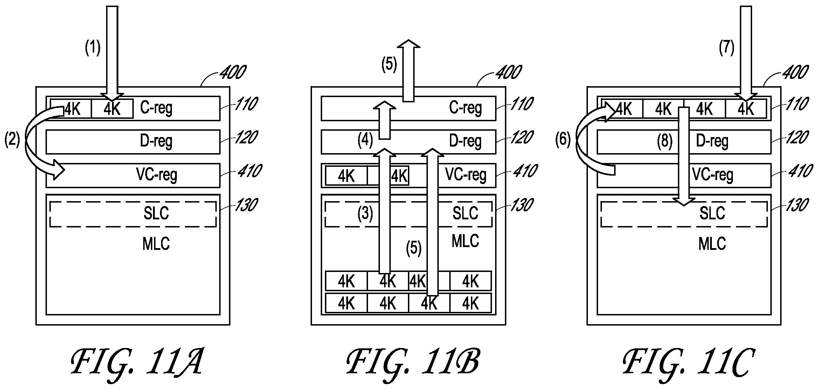

With three separate registers to buffer NAND flash memory pages or portions thereof, data can be temporarily loaded into the cache register 110 one segment at a time and an interleaved page cache read operation can be performed. Figures 11A, 11B, and 11C are diagrams that illustrate a process of temporarily loading data to be programmed to an array in a register with an interleaved read operation according to an embodiment.

Referring to Figure 11A, data can be loaded into the cache register 110 one segment at a time. The cache register 110 can receive first data to be programmed to the array 130 from the controller 310 via a channel. When the cache register 110 holds a full page of data, the full page of data can be provided from the cache register 110 to the array 130 and programmed to the array 130. While the cache register 110 holds less than an entire page of data, the controller 310 can receive a read request, such as page cache read request or a page read request, from the host to read data from the array 130 of the NAND flash memory device 400. Based on tracking information in one or more registers or firmware of the controller 310, the controller 310 can detect that less than a full page of data to be programmed to the array is held by the cache register 110. Then the controller 310 can generate a Move to VCache command. The NAND flash memory device 400 can execute the Move to VCache command to move the first data held by the cache register 110 to the virtual cache register 410.

As shown in Figure 11B, second data from the array 130 can be loaded in the data register 120 while the first data is held by the virtual cache register 410. The second data can include a full page of data in some instances. The second data is then moved from the data register 120 to the cache register 110. When the second data has been loaded to the cache register 110, the data register 120 is ready to receive a new data from the array 130. The second data can be provided from the cache register 110 to a contact of the NAND flash memory device 400. This can output the second data from the NAND flash memory device 400 to the controller 310. While the second data is being provided from the cache register 110 to an output of the NAND flash memory device 400, additional data from the array 130, such as a new page of data, can be loaded into the data register 120. The controller 310 can generate commands to cause the NAND flash memory device 400 to repeat the operations shown in Figure 11B as many times as desired while the virtual cache register 410 holds the first data. The controller 310 can generate commands to cause the NAND flash memory device 400 to perform other read and/or program operations as many times as desired while the virtual cache register 410 holds the first data

In response to detecting that read and/or programming operations are completed, the controller 310 can generate a Move from VCache command and provide this command to the NAND flash memory device 400. Referring now to Figure 11C, after the page cache read operation(s) are completed, the first data held by the virtual cache register 410 can be moved to the cache register 110. Segments of data to be programmed to the array 130 can then be loaded into the cache register 110. When a full page of data has been loaded into the cache register 110, the NAND flash memory device 400 can provide the full page of data from the cache register 110 to the array 130 and program this data to the array 130.

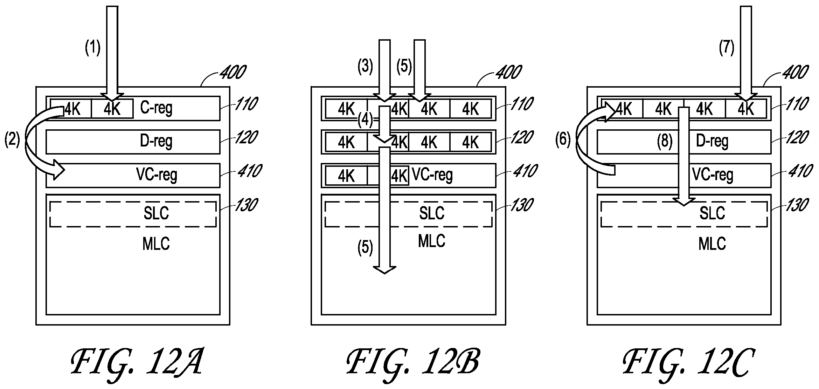

A register architecture with three separate registers on a NAND flash memory device to buffer NAND flash memory pages can also temporarily load data to a cache register 110 one segment at a time and perform an interleaved page cache program operation to program different data to the array 130. Figures 12A, 12B, and 12C are diagrams that illustrate a process of temporarily loading first data to be programmed to an array in a register with an interleaved programming operation to program second data to the array according to an embodiment.

Referring to Figure 12A, data can be loaded into the cache register 110 one segment at a time. The cache register 110 can receive first data to be programmed to the array 130 from the controller 310 via a channel. When the cache register 110 holds a full page of data, the full page of data can be provided from the cache register 110 to the array 130. While the cache register 110 holds less than an entire page of data, the controller 310 can receive a page cache program request from the host to program a page of data to the array 130 of the NAND flash memory device 400. Based on tracking information in one or more registers or firmware of the controller 310, the controller 310 can detect that less than a full page of data to be programmed to the array 130 is held by the cache register 110. Then the controller 310 can generate a Move to VCache command. The NAND flash memory device 400 can execute the Move to VCache command to move the first data held by the cache register 110 to the virtual cache register 410.

As shown in Figure 12B, second data including a page of data to be programmed to the array 130 can be loaded to the cache register 110 while the first data is held by the virtual cache register 410. The second data is then moved from the cache register 110 to the data register 120. When the second data has been moved to the data register 120, the cache register 110 is ready to receive new data from the controller 310. The second data can be provided from the data register 120 to the array 130. Then the second data can be programmed to the array 130. While the second data is being provided from the data register 120 to the array 130, another page of data received by the NAND flash memory device 400 can be loaded into the cache register 110. The controller 310 can generate commands to cause the NAND flash memory device 400 to repeat the operations shown in Figure 12B as many times as desired while the virtual cache register 410 holds the first data. The controller 310 can generate commands to cause the NAND flash memory device 400 to perform other program and/or read operations as many times as desired while the virtual cache register 410 holds the first data.

In response to detecting that cache page program operations are completed, the controller 310 can generate a Move from VCache command and provide this command to the NAND flash memory device 400. Referring now to Figure 12C, after the page cache program operation(s) are completed, the first data held by the virtual cache register 410 can be moved to the cache register 110. Segments of data to be programmed to the array 130 can then be loaded into the cache register 110. When a full page of data has been loaded into the cache register 110, the NAND flash memory device 400 can provide the full page of data from the cache register 110 to the array 130 and program these data to the array 130.

Any combination of features discussed with reference with any one of Figures 9 to 12C can be combined with each other, as appropriate. Moreover, the principles and advantages associated with the register architecture described with reference to Figures 9 to 12C can be implemented in connection with any operation in which there is a need to preserve data held in a register while one or more other operations accessing the array 130 are performed.

In the embodiments described above, non-volatile memories and/or controllers be implemented in any electronic device with a need for non-volatile memory to store data. As such, the non-volatile memories and/or controllers and associated methods described herein can be incorporated in various electronic devices. Examples of the electronic devices can include, but are not limited to, consumer electronic products, electronic circuits, electronic circuit components, parts of the consumer electronic products, electronic test equipment, etc. Examples of the consumer electronic products include, but are not limited to, a mobile phone (for example, a smart phone), a telephone, a television, a computer monitor, a computer, a hand-held computer, a laptop computer, a tablet computer, a personal digital assistant (PDA), a microwave, a refrigerator, a stereo system, a cassette recorder or player, a DVD player, a CD player, a VCR, an MP3 player, a radio, a camcorder, an optical camera, a digital camera, a portable memory chip, a washer, a dryer, a washer/dryer, a copier, a facsimile machine, a scanner, a multi-function peripheral device, a wrist watch, a clock, etc. Further, the electronic device can include unfinished products. The disclosed techniques are not applicable to mental steps, and are not performed within the human mind or by a human writing on paper.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to." The foregoing description and claims may refer to elements or features as being "connected" or "coupled" together. As used herein, unless expressly stated to the contrary, "connected" means that one element/feature is directly or indirectly connected to another element/feature, and not necessarily mechanically. Likewise, unless expressly stated to the contrary, "coupled" means that one element/feature is directly or indirectly coupled to another element/feature, and not necessarily mechanically. Thus, although the drawings illustrate various examples of arrangements of elements and components, additional intervening elements, devices, features, or components may be present in an actual embodiment. Additionally, the words "herein," "above," "below," and words of similar import, when used in this application, shall refer to this application as a whole and not to any particular portions of this application. Where the context permits, words in the above Detailed Description using the singular or plural number may also include the plural or singular number respectively. The word "or" in reference to a list of two or more items, that word covers all of the following interpretations of the word: any of the items in the list, all of the items in the list, and any combination of the items in the list.

Any combination of the features of the methods described herein may be embodied in code stored on a non-transitory computer readable medium. When executed, the code stored on the non-transitory computer readable medium may cause some or all of any of the methods described herein to be performed. It will be understood that any of the methods discussed herein may include greater or fewer operations and that the operations may be performed in any order, as appropriate. For example, while processes or blocks are presented in a given order, alternative embodiments may perform routines having steps, or employ systems having blocks, in a different order, and some processes or blocks may be deleted, moved, added, subdivided, combined, and/or modified. Each of these processes or blocks may be implemented in a variety of different ways. Also, while processes or blocks are at times shown as being performed in series, these processes or blocks may instead be performed in parallel, or may be performed at different times. Moreover, it will be understood that the methods discussed herein are performed at least partly by physical circuitry. Accordingly, the claims are not intended to cover purely mental processes or abstract ideas.

Various embodiments have been described above. Although described with reference to these specific embodiments, the descriptions are intended to be illustrative and are not intended to be limiting. Various modifications and applications may occur to those skilled in the art. The scope of the invention is defined by the appended claims.

## Claims

1. An apparatus (300) comprising:
a controller (310);
a first non-volatile memory device (320a, 320b, 320c, 320d, 400, 420); and
a second non-volatile memory device (320a, 320b, 320c, 320d, 400, 420),
the first non-volatile memory device (320a, 320b, 320c, 320d, 400, 420) comprising:
a first array (130, 130a, 130b) of non-volatile memory cells configured to store data;
a first register (110, 110a, 110b, 110c, 110d, 120, 120a, 120b, 120c, 120d, 410, 410a, 410b) thereon comprising volatile memory; and
a second register (110, 110a, 110b, 110c, 110d, 120, 120a, 120b, 120c, 120d, 410, 410a, 410b) thereon comprising volatile memory, wherein the first register (110, 110a, 110b, 110c, 110d, 120, 120a, 120b, 120c, 120d, 410, 410a, 410b) comprises one of a cache register or a data register, and wherein the second register (110, 110a, 110b, 110c, 110d, 120, 120a, 120b, 120c, 120d, 410, 410a, 410b) comprises the other of the cache register or the data register;
the second non-volatile memory device (320a, 320b, 320c, 320d, 400, 420) comprising:
a second array (130, 130a, 130b) of non-volatile memory cells configured to store data;
a third register (110, 110a, 110b, 110c, 110d, 120, 120a, 120b, 120c, 120d, 410, 410a, 410b) comprising volatile memory; and
a fourth register (110, 110a, 110b, 110c, 110d, 120, 120a, 120b, 120c, 120d, 410, 410a, 410b) comprising volatile memory, wherein the third register (110, 110a, 110b, 110c, 110d, 120, 120a, 120b, 120c, 120d, 410, 410a, 410b) comprises one of a cache register or a data register, and wherein the fourth register (110, 110a, 110b, 110c, 110d, 120, 120a, 120b, 120c, 120d, 410, 410a, 410b) comprises the other of the cache register or the data register,
wherein the controller (310) is configured to generate commands to maintain data in a distributed virtual cache implemented by the data registers of the first non-volatile memory device (320a, 320b, 320c, 320d, 400, 420) and the second non-volatile memory device (320a, 320b, 320c, 320d, 400, 420), wherein the controller is configured to generate commands to cause the first non-volatile memory (320a, 320b, 320c, 320d, 400, 420) to:
load programming data to be programmed to the first array (130, 130a, 130b) of non-volatile memory cells to the first register (110, 110a, 110b, 110c, 110d, 120, 120a, 120b, 120c, 120d, 410, 410a, 410b);
load read data read from the first array (130, 130a, 130b) of non-volatile memory cells to the second register (110, 110a, 110b, 110c, 110d, 120, 120a, 120b, 120c, 120d, 410, 410a, 410b);
provide the read data from the second register (110, 110a, 110b, 110c, 110d, 120, 120a, 120b, 120c, 120d, 410, 410a, 410b) to the controller (310) while the first register (110, 110a, 110b, 110c, 110d, 120, 120a, 120b, 120c, 120d, 410, 410a, 410b) is holding the programming data to be programmed to the first array (130, 130a, 130b) of non-volatile memory cells;
move the programming data to be programmed from the first register (110, 110a, 110b, 110c, 110d, 120, 120a, 120b, 120c, 120d, 410, 410a, 410b) to the second register (110, 110a, 110b, 110c, 110d, 120, 120a, 120b, 120c, 120d, 410, 410a, 410b) responsive to determining that the programming data is less than a page of data and to subsequently load second read data from the first array (130, 130a, 130b) of non-volatile memory cells to the first register (110, 110a, 110b, 110c, 110d, 120, 120a, 120b, 120c, 120d, 410, 410a, 410b);
provide the second read data in the first register (110, 110a, 110b, 110c, 110d, 120, 120a, 120b, 120c, 120d, 410, 410a, 410b) to the controller (310); and
move the programming data to be programmed from the second register (110, 110a, 110b, 110c, 110d, 120, 120a, 120b, 120c, 120d, 410, 410a, 410b) to the first register (110, 110a, 110b, 110c, 110d, 120, 120a, 120b, 120c, 120d, 410, 410a, 410b).

2. The apparatus (300) of Claim 1, wherein the first non-volatile memory device (320a, 320b, 320c, 320d, 400, 420) comprises a NAND flash memory device.

3. The apparatus of claim 1, wherein the controller (310) is configured to generate commands to cause the second non-volatile memory (320a, 320b, 320c, 320d, 400, 420) to:
load second programming data to be programmed to the second array (130, 130a, 130b) of non-volatile memory cells to the third register (110, 110a, 110b, 110c, 110d, 120, 120a, 120b, 120c, 120d, 410, 410a, 410b);
load second read data read from the second array (130, 130a, 130b) of non-volatile memory cells to the fourth register (110, 110a, 110b, 110c, 110d, 120, 120a, 120b, 120c, 120d, 410, 410a, 410b); and
provide the second read data from the fourth register (110, 110a, 110b, 110c, 110d, 120, 120a, 120b, 120c, 120d, 410, 410a, 410b) to the controller (310) while the third register (110, 110a, 110b, 110c, 110d, 120, 120a, 120b, 120c, 120d, 410, 410a, 410b) is holding the second programming data to be programmed to the second array (130, 130a, 130b) of non-volatile memory cells.

4. The apparatus (300) of Claim 1,
wherein the controller (310) is configured to generate commands to cause the second non-volatile memory to:
load second programming data to be programmed to the second array (130, 130a, 130b) of non-volatile memory to the third register (110, 110a, 110b, 110c, 110d, 120, 120a, 120b, 120c, 120d, 410, 410a, 410b);
return the second programming data to be programmed stored in the third register (110, 110a, 110b, 110c, 110d, 120, 120a, 120b, 120c, 120d, 410, 410a, 410b) to the controller (310) prior to the data to be programmed being programmed to the second array (130, 130a, 130b) of non-volatile memory cells.

5. The apparatus (300) of Claim 1, wherein the controller (310) is configured to generate commands to cause the first non-volatile memory (320a, 320b, 320c, 320d, 400, 420) to load the programming data to be programmed to the first array (130, 130a, 130b) of non-volatile memory cells to the first register (110, 110a, 110b, 110c, 110d, 120, 120a, 120b, 120c, 120d, 410, 410a, 410b) without using the second register (110, 110a, 110b, 110c, 110d, 120, 120a, 120b, 120c, 120d, 410, 410a, 410b).

6. The apparatus (300) of Claim 1, wherein the controller (310) is configured to generate one or more commands to cause the first non-volatile memory device (320a, 320b, 320c, 320d, 400, 420) to move the programming data to be programmed held in the first register (110, 110a, 110b, 110c, 110d, 120, 120a, 120b, 120c, 120d, 410, 410a, 410b) to the second register (110, 110a, 110b, 110c, 110d, 120, 120a, 120b, 120c, 120d, 410, 410a, 410b), and to subsequently load second read data from the first array (130, 130a, 130b) to the first register (110, 110a, 110b, 110c, 110d, 120, 120a, 120b, 120c, 120d, 410, 410a, 410b), provide the second read data from the first array (130, 130a, 130b) in the second register (110, 110a, 110b, 110c, 110d, 120, 120a, 120b, 120c, 120d, 410, 410a, 410b) to the controller (310), and move the programming data to be programmed from the second register (110, 110a, 110b, 110c, 110d, 120, 120a, 120b, 120c, 120d, 410, 410a, 410b) to the first register (110, 110a, 110b, 110c, 110d, 120, 120a, 120b, 120c, 120d, 410, 410a, 410b).

7. The apparatus (300) of Claim 1, wherein the controller (310) is configured to provide commands to the first non-volatile memory (320a, 320b, 320c, 320d, 400, 420) such that separate registers (110, 110a, 110b, 110c, 110d, 120, 120a, 120b, 120c, 120d, 410, 410a, 410b) are used to hold data read from the first array (130, 130a, 130b) and data to be programmed to the first array (130, 130a, 130b).

8. The apparatus (300) of Claim 1, wherein the controller (310) is configured to retrieve data from the first register (110, 110a, 110b, 110c, 110d, 120, 120a, 120b, 120c, 120d, 410, 410a, 410b) prior to the retrieved data being programmed to the first array (130, 130a, 130b) of non-volatile memory cells.

9. An electronically-implemented method of translating requests to access a non-volatile memory device (320a, 320b, 320c, 320d, 400, 420), the method comprising:
as implemented by a controller (310) of a non-volatile memory device (320a, 320b, 320c, 320d, 400, 420) configured to generate commands to maintain data in a distributed virtual cache implemented by data registers of the non-volatile memory device (320a, 320b, 320c, 320d, 400, 420) and another non-volatile memory device (320a, 320b, 320c, 320d, 400, 420);
translating a first request to program programming data to an array (130, 130a, 130b) of non-volatile memory cells of the non-volatile memory device (320a, 320b, 320c, 320d, 400, 420) into one or more programming commands that cause the programming data to be loaded to volatile memory of a first register (110, 110a, 110b, 110c, 110d, 120, 120a, 120b, 120c, 120d, 410, 410a, 410b) of the non-volatile memory device (320a, 320b, 320c, 320d, 400, 420) and subsequently programmed to the array (130, 130a, 130b) of non-volatile memory cells;
receiving a second request to access read data from the non-volatile memory device (320a, 320b, 320c, 320d, 400, 420) prior to the programming data associated with the first request being programmed to the array (130, 130a, 130b) of non-volatile memory cells;
translating the second request to access the read data from the non-volatile memory device (320a, 320b, 320c, 320d, 400, 420) into one or more read commands that cause the non-volatile memory device (320a, 320b, 320c, 320d, 400, 420) to access the read data from the array (130, 130a, 130b) of non-volatile memory cells and load the read data to volatile memory of a second register (110, 110a, 110b, 110c, 110d, 120, 120a, 120b, 120c, 120d, 410, 410a, 410b) of the non-volatile memory device (320a, 320b, 320c, 320d, 400, 420) such that the first register (110, 110a, 110b, 110c, 110d, 120, 120a, 120b, 120c, 120d, 410, 410a, 410b) can concurrently hold at least a portion of the programming data and the read data associated with the second request can be read from the non-volatile memory device (320a, 320b, 320c, 320d, 400, 420) prior to the programming data associated with the first request being programmed to the array (130, 130a, 10b) of non-volatile memory cells,
generating one or more commands to cause the non-volatile memory device (320a, 320b, 320c, 320d, 400, 420) to move the programming data to be programmed from the first register (110, 110a, 110b, 110c, 110d, 120, 120a, 120b, 120c, 120d, 410, 410a, 410b) to the second register (110, 110a, 110b, 110c, 110d, 120, 120a, 120b, 120c, 120d, 410, 410a, 410b) responsive to determining that the programming data is less than a page of data, and to subsequently load second read data from the array (130, 130a, 130b) of non-volatile memory cells to the first register (110, 110a, 110b, 110c, 110d, 120, 120a, 120b, 120c, 120d, 410, 410a, 410b), provide the second read data in the first register (110, 110a, 110b, 110c, 110d, 120, 120a, 120b, 120c, 120d, 410, 410a, 410b) to the controller (310), and move the programming data to be programmed from the second register (110, 110a, 110b, 110c, 110d, 120, 120a, 120b, 120c, 120d, 410, 410a, 410b) to the first register (110, 110a, 110b, 110c, 110d, 120, 120a, 120b, 120c, 120d, 410, 410a, 410b).

10. The method of Claim 9, wherein the first register (110, 110a, 110b, 110c, 110d, 120, 120a, 120b, 120c, 120d, 410, 410a, 410b) is a data register and the second register (110, 110a, 110b, 110c, 110d, 120, 120a, 120b, 120c, 120d, 410, 410a, 410b) is a cache register.

11. The method of Claim 9, wherein the first register (110, 110a, 110b, 110c, 110d, 120, 120a, 120b, 120c, 120d, 410, 410a, 410b) is a cache register and the second register (110, 110a, 110b, 110c, 110d, 120, 120a, 120b, 120c, 120d, 410, 410a, 410b) is a data register.

12. The method of Claim 9, wherein the method further comprises translating a third request to access at least a portion of the programming data from the non-volatile memory device (320a, 320b, 320c, 320d, 400, 420) into one or more read while load commands that cause data of the programming data held in the first register (110, 110a, 110b, 110c, 110d, 120, 120a, 120b, 120c, 120d, 410, 410a, 410b) that is not stored in the array (130, 130a, 130b) to be retrieved from the non-volatile memory device (320a, 320b, 320c, 320d, 400, 420).

13. The method of Claim 9, wherein the method further comprises translating another request to program data to the array (130, 130a, 130b) of the non-volatile memory into one or more other programming commands that cause one segment of programming data to be loaded to volatile memory of the first register (110, 110a, 110b, 110c, 110d, 120, 120a, 120b, 120c, 120d, 410, 410a, 410b) of the non-volatile memory device (320a, 320b, 320c, 320d, 400, 420) such that the one segment of programming data can be programmed to the array (130, 130a, 130b) with the programming data associated with the first request in a single page program operation.

14. The method of Claim 9, wherein the non-volatile memory device (320a, 320b, 320c, 320d, 400, 420) comprises a die having multiple planes of non-volatile memory.

15. The method of claim 9, further comprising:
loading second programming data to be programmed to another array (130, 130a, 130b) of non-volatile memory cells of the another non-volatile memory device (320a, 320b, 320c, 320d, 400, 420) to a third register (110, 110a, 110b, 110c, 110d, 120, 120a, 120b, 120c, 120d, 410, 410a, 410b) of the another non-volatile memory device (320a, 320b, 320c, 320d, 400, 420);
loading second read data read from the another array (130, 130a, 130b) of non-volatile memory cells to a fourth register (110, 110a, 110b, 110c, 110d, 120, 120a, 120b, 120c, 120d, 410, 410a, 410b) of the another non-volatile memory device (320a, 320b, 320c, 320d, 400, 420); and
providing the second read data from the fourth register (110, 110a, 110b, 110c, 110d, 120, 120a, 120b, 120c, 120d, 410, 410a, 410b) to the controller (310) while the third register (110, 110a, 110b, 110c, 110d, 120, 120a, 120b, 120c, 120d, 410, 410a, 410b) is holding the second programming data to be programmed to the another array (130, 130a, 130b) of non-volatile memory cells.

## Patentansprüche

1. Vorrichtung (300), die Folgendes umfasst:
eine Steuerung (310);
eine erste nicht-flüchtige Speichervorrichtung (320a, 320b, 320c, 320d, 400, 420); und
eine zweite nicht-flüchtige Speichervorrichtung (320a, 320b, 320c, 320d, 400, 420),
wobei die erste nicht-flüchtige Speichervorrichtung (320a, 320b, 320c, 320d, 400, 420) Folgendes umfasst:
ein erstes Array (130, 130a, 130b) von nicht-flüchtigen Speicherzellen, die zum Speichern von Daten konfiguriert sind;
ein erstes Register (110, 110a, 110b, 110c, 110d, 120, 120a, 120b, 120c, 120d, 410, 410a, 410b) darauf, das einen flüchtigen Speicher umfasst; und
ein zweites Register (110, 110a, 110b, 110c, 110d, 120, 120a, 120b, 120c, 120d, 410, 410a, 410b) darauf, das einen flüchtigen Speicher umfasst,
_wobei das erste Register (110, 110a, 110b, 110c, 110d, 120, 120a, 120b, 120c, 120d, 410, 410a, 410b) eines von einem Cache-Register oder einem Datenregister umfasst, und
_wobei das zweite Register (110, 110a, 110b, 110c, 110d, 120, 120a, 120b, 120c, 120d, 410, 410a, 410b) das andere von dem Cache-Register oder dem Datenregister umfasst;
wobei die zweite nicht-flüchtige Speichervorrichtung (320a, 320b, 320c, 320d, 400, 420) Folgendes umfasst:
ein zweites Array (130, 130a, 130b) von nicht-flüchtigen Speicherzellen, die zum Speichern von Daten konfiguriert sind;
ein drittes Register (110, 110a, 110b, 110c, 110d, 120, 120a, 120b, 120c, 120d, 410, 410a, 410b), das einen flüchtigen Speicher umfasst; und
ein viertes Register (110, 110a, 110b, 110c, 110d, 120, 120a, 120b, 120c, 120d, 410, 410a, 410b), das einen flüchtigen Speicher umfasst,
_wobei das dritte Register (110, 110a, 110b, 110c, 110d, 120, 120a, 120b, 120c, 120d, 410, 410a, 410b) eines von einem Cache-Register oder einem Datenregister umfasst, und
_wobei das vierte Register (110, 110a, 110b, 110c, 110d, 120, 120a, 120b, 120c, 120d, 410, 410a, 410b) das andere von dem Cache-Register oder dem Datenregister umfasst,
wobei die Steuerung (310) dafür konfiguriert ist, Befehle zu erzeugen, um Daten in einem verteilten virtuellen Cache zu halten, der durch die Datenregister der ersten nicht-flüchtigen Speichervorrichtung (320a, 320b, 320c, 320d, 400, 420) und der zweiten nicht-flüchtigen Speichervorrichtung (320a, 320b, 320c, 320d, 400, 420) implementiert ist,
_wobei die Steuerung dafür konfiguriert ist, Befehle zu erzeugen, um den ersten nicht-flüchtigen Speicher (320a, 320b, 320c, 320d, 400, 420) zu Folgendem zu veranlassen:
Laden von Programmierdaten, die in das erste Array (130, 130a, 130b) von nicht-flüchtigen Speicherzellen zu programmieren sind, in das erste Register (110, 110a, 110b, 110c, 110d, 120, 120a, 120b, 120c, 120d, 410, 410a, 410b);
Laden von Lesedaten, die aus dem ersten Array (130, 130a, 130b) von nicht-flüchtigen Speicherzellen gelesen werden, in das zweite Register (110, 110a, 110b, 110c, 110d, 120, 120a, 120b, 120c, 120d, 410, 410a, 410b);
Bereitstellen der Lesedaten aus dem zweiten Register (110, 110a, 110b, 110c, 110d, 120, 120a, 120b, 120c, 120d, 410, 410a, 410b) an die Steuerung (310),
_während das erste Register (110, 110a, 110b, 110c, 110d, 120, 120a, 120b, 120c, 120d, 410, 410a, 410b)
die Programmierdaten hält, die in das erste Array (130, 130a, 130b) von nicht-flüchtigen Speicherzellen zu programmieren sind.
Verschieben der zu programmierenden Programmierdaten von dem ersten Register (110, 110a, 110b, 110c, 110d, 120, 120a, 120b, 120c, 120d, 410, 410a, 410b) zu dem zweiten Register (110, 110a, 110b, 110c, 110d, 120, 120a, 120b, 120c, 120d, 410, 410a, 410b)
_ als Reaktion auf die Bestimmung, dass die Programmierdaten weniger als eine Seite von Daten sind, und anschließendes Laden zweiter Lesedaten aus dem ersten Array (130, 130a, 130b) von nicht-flüchtigen Speicherzellen in das erste Register (110, 110a, 110b, 110c, 110d, 120, 120a, 120b, 120c, 120d, 410, 410a, 410b);
Bereitstellen der zweiten Lesedaten in dem ersten Register (110, 110a, 110b, 110c, 110d, 120, 120a, 120b, 120c, 120d, 410, 410a, 410b) an die Steuerung (310); und
Verschieben der zu programmierenden Programmierdaten von dem zweiten Register (110, 110a, 110b, 110c, 110d, 120, 120a, 120b, 120c, 120d, 410, 410a, 410b) zu dem ersten Register (110, 110a, 110b, 110c, 110d, 120, 120a, 120b, 120c, 120d, 410, 410a, 410b).

2. Vorrichtung (300) nach Anspruch 1,
_ wobei die erste nicht-flüchtige Speichervorrichtung (320a, 320b, 320c, 320d, 400, 420) eine NAND-Flash-Speichervorrichtung umfasst.

3. Vorrichtung nach Anspruch 1,
_ wobei die Steuerung (310) dafür konfiguriert ist, Befehle zu erzeugen, um den zweiten nicht-flüchtigen Speicher (320a, 320b, 320c, 320d, 400, 420) zu Folgendem zu veranlassen:
Laden von zweiten Programmierdaten, die in das zweite Array (130, 130a, 130b) der nicht-flüchtigen Speicherzellen zu programmieren sind, in das dritte Register (110, 110a, 110b, 110c, 110d, 120, 120a, 120b, 120c, 120d, 410, 410a, 410b);
Laden von zweiten Lesedaten, die aus dem zweiten Array (130, 130a, 130b) von nicht-flüchtigen Speicherzellen gelesen wurden, in das vierte Register (110, 110a, 110b, 110c, 110d, 120, 120a, 120b, 120c, 120d, 410, 410a, 410b); und
Bereitstellen der zweiten Lesedaten aus dem vierten Register (110, 110a, 110b, 110c, 110d, 120, 120a, 120b, 120c, 120d, 410, 410a, 410b) an die Steuerung (310),
_ während das dritte Register (110, 110a, 110b, 110c, 110d, 120, 120a, 120b, 120c, 120d, 410, 410a, 410b)
die zweiten Programmierdaten hält, die in das zweite Array (130, 130a, 130b) von nicht-flüchtigen Speicherzellen zu programmieren sind.

4. Vorrichtung (300) nach Anspruch 1,
_wobei die Steuerung (310) dafür konfiguriert ist, Befehle zu erzeugen, um den zweiten nicht-flüchtigen Speicher zu Folgendem zu veranlassen:
Laden von zweiten Programmierdaten, die in das zweite Array (130, 130a, 130b) des nicht-flüchtigen Speichers zu programmieren sind, in das dritte Register (110, 110a, 110b, 110c, 110d, 120, 120a, 120b, 120c, 120d, 410, 410a, 410b);
Rückgeben der zweiten zu programmierenden Daten, die in dem dritten Register (110, 110a, 110b, 110c, 110d, 120, 120a, 120b, 120c, 120d, 410, 410a, 410b) gespeichert sind, an die Steuerung (310),
_bevor die zu programmierenden Daten in das zweite Array (130, 130a, 130b) von nicht-flüchtigen Speicherzellen programmiert werden.

5. Vorrichtung (300) nach Anspruch 1,
_wobei die Steuerung (310) dafür konfiguriert ist, Befehle zu erzeugen, um den ersten nicht-flüchtigen Speicher (320a, 320b, 320c, 320d, 400, 420) zu Folgendem zu veranlassen:
Laden von Programmierdaten, die in das erste Array (130, 130a, 130b) von nicht-flüchtigen Speicherzellen zu programmieren sind, in das erste Register (110, 110a, 110b, 110c, 110d, 120, 120a, 120b, 120c, 120d, 410, 410a, 410b)
_ohne Verwendung des zweiten Registers (110, 110a, 110b, 110c, 110d, 120, 120a, 120b, 120c, 120d, 410, 410a, 410b).

6. Vorrichtung (300) nach Anspruch 1,
_wobei die Steuerung (310) dafür konfiguriert ist, einen oder mehrere Befehle zu erzeugen, um die erste nicht-flüchtige Speichervorrichtung (320a, 320b, 320c, 320d, 400, 420) zu Folgendem zu veranlassen:
_Verschieben der zu programmierenden Programmierdaten, die in dem ersten Register (110, 110a, 110b, 110c, 110d, 120, 120a, 120b, 120c, 120d, 410, 410a, 410b) gehalten werden, zu dem zweiten Register (110, 110a, 110b, 110c, 110d, 120, 120a, 120b, 120c, 120d, 410, 410a, 410b) und
_anschließend Laden von zweiten Lesedaten aus dem ersten Array (130, 130a, 130b) in das erste Register (110, 110a, 110b, 110c, 110d, 120, 120a, 120b, 120c, 120d, 410, 410a, 410b),
_Bereitstellen der zweiten Lesedaten aus dem ersten Array (130, 130a, 130b) in dem zweiten Register (110, 110a, 110b, 110c, 110d, 120, 120a, 120b, 120c, 120d, 410, 410a, 410b) an die Steuerung (310), und
_Verschieben der zu programmierenden Programmierdaten von dem zweiten Register (110, 110a, 110b, 110c, 110d, 120, 120a, 120b, 120c, 120d, 410, 410a, 410b) zu dem ersten Register (110, 110a, 110b, 110c, 110d, 120, 120a, 120b, 120c, 120d, 410, 410a, 410b).

7. Vorrichtung (300) nach Anspruch 1,
_wobei die Steuerung (310) dafür konfiguriert ist, Befehle an den ersten nicht-flüchtigen Speicher (320a, 320b, 320c, 320d, 400, 420) zu liefern,
_so dass separate Register (110, 110a, 110b, 110c, 110d, 120, 120a, 120b, 120c, 120d, 410, 410a, 410b) verwendet werden, um aus dem ersten Array (130, 130a, 130b) gelesene Daten und in das erste Array (130, 130a, 130b) zu programmierende Daten zu halten.

8. Vorrichtung (300) nach Anspruch 1,
_wobei die Steuerung (310) dafür konfiguriert ist, Daten aus dem ersten Register (110, 110a, 110b, 110c, 110d, 120, 120a, 120b, 120c, 120d, 410, 410a, 410b) abzurufen,
_bevor die abgerufenen Daten in das erste Array (130, 130a, 130b) von nicht-flüchtigen Speicherzellen programmiert werden.

9. Elektronisch implementiertes Verfahren zum Übersetzen von Anfragen zum Zugriff auf eine nicht-flüchtige Speichervorrichtung (320a, 320b, 320c, 320d, 400, 420),
- wobei das Verfahren Folgendes umfasst:
wie durch eine Steuerung (310) einer nicht-flüchtigen Speichervorrichtung (320a, 320b, 320c, 320d, 400, 420) implementiert, die dafür konfiguriert ist, Befehle zu erzeugen, um Daten in einem verteilten virtuellen Cache zu halten,
_der durch Datenregister der nicht-flüchtigen Speichervorrichtung (320a, 320b, 320c, 320d, 400, 420) und einer anderen nicht-flüchtigen Speichervorrichtung (320a, 320b, 320c, 320d, 400, 420) implementiert wird;
Übersetzen einer ersten Anforderung zum Programmieren von Programmierdaten in ein Array (130, 130a, 130b) von nicht-flüchtigen Speicherzellen der nicht-flüchtigen Speichervorrichtung (320a, 320b, 320c, 320d, 400, 420) in einen oder mehrere Programmierbefehle,
_die bewirken, dass die Programmierdaten in den flüchtigen Speicher eines ersten Registers (110, 110a, 110b, 110c, 110d, 120, 120a, 120b, 120c, 120d, 410, 410a, 410b) der nicht-flüchtigen Speichereinrichtung (320a, 320b, 320c, 320d, 400, 420) geladen werden, und
_die anschließend in das Array (130, 130a, 130b) der nicht-flüchtigen Speicherzellen programmiert werden;
Empfangen einer zweiten Anforderung zum Zugriff auf Lesedaten aus der nicht-flüchtigen Speichervorrichtung (320a, 320b, 320c, 320d, 400, 420),
- bevor die mit der ersten Anforderung verbundenen Programmierdaten in das Array (130, 130a, 130b) nicht-flüchtiger Speicherzellen programmiert werden;
Übersetzen der zweiten Anforderung zum Zugriff auf die Lesedaten aus der nicht-flüchtigen Speichervorrichtung (320a, 320b, 320c, 320d, 400, 420) in einen oder mehrere Lesebefehle,
_ die die nicht-flüchtige Speichervorrichtung (320a, 320b, 320c, 320d, 400, 420) veranlassen,
_ auf die gelesenen Daten aus dem Array (130, 130a, 130b) der nicht-flüchtigen Speicherzellen zuzugreifen und
_ die gelesenen Daten in den flüchtigen Speicher eines zweiten Registers (110, 110a, 110b, 110c, 110d, 120, 120a, 120b, 120c, 120d, 410, 410a, 410b) der nicht-flüchtigen Speichereinrichtung (320a, 320b, 320c, 320d, 400, 420) zu laden,
_ so dass das erste Register (110, 110a, 110b, 110c, 110d, 120, 120a, 120b, 120c, 120d, 410, 410a, 410b) gleichzeitig mindestens einen Teil der Programmierdaten halten kann und
- die der zweiten Anforderung zugeordneten Lesedaten aus der nicht-flüchtigen Speichereinrichtung (320a, 320b, 320c, 320d, 400, 420) gelesen werden können,
- bevor die mit der ersten Anforderung verbundenen Programmierdaten in das Array (130, 130a, 10b) nicht-flüchtiger Speicherzellen programmiert werden;
Erzeugen eines oder mehrerer Befehle, um die nicht-flüchtige Speichervorrichtung (320a, 320b, 320c, 320d, 400, 420) zu Folgendem zu veranlassen:
_ Verschieben der zu programmierenden Programmierdaten von dem ersten Register (110, 110a, 110b, 110c, 110d, 120, 120a, 120b, 120c, 120d, 410, 410a, 410b) zu dem zweiten Register (110, 110a, 110b, 110c, 110d, 120, 120a, 120b, 120c, 120d, 410, 410a, 410b)
- als Reaktion auf die Bestimmung, dass die Programmierdaten weniger als eine Seite von Daten sind, und
_ anschließend Laden zweiter Lesedaten aus dem Array (130, 130a, 130b) von nicht-flüchtigen Speicherzellen in das erste Register (110, 110a, 110b, 110c, 110d, 120, 120a, 120b, 120c, 120d, 410, 410a, 410b),
- Bereitstellen der zweiten Lesedaten in dem ersten Register (110, 110a, 110b, 110c, 110d, 120, 120a, 120b, 120c, 120d, 410, 410a, 410b) an die Steuerung (310), und
_ Verschieben der zu programmierenden Programmierdaten von dem zweiten Register (110, 110a, 110b, 110c, 110d, 120, 120a, 120b, 120c, 120d, 410, 410a, 410b) zu dem ersten Register (110, 110a, 110b, 110c, 110d, 120, 120a, 120b, 120c, 120d, 410, 410a, 410b).

10. Verfahren nach Anspruch 9,
_ wobei das erste Register (110, 110a, 110b, 110c, 110d, 120, 120a, 120b, 120c, 120d, 410, 410a, 410b) ein Datenregister ist und das zweite Register (110, 110a, 110b, 110c, 110d, 120, 120a, 120b, 120c, 120d, 410, 410a, 410b) ein Cache-Register ist.

11. Verfahren nach Anspruch 9,
_wobei das erste Register (110, 110a, 110b, 110c, 110d, 120, 120a, 120b, 120c, 120d, 410, 410a, 410b) ein Cache-Register ist und das zweite Register (110, 110a, 110b, 110c, 110d, 120, 120a, 120b, 120c, 120d, 410, 410a, 410b) ein Datenregister ist.

12. Verfahren nach Anspruch 9,
_ wobei das Verfahren ferner das Übersetzen einer dritten Anforderung zum Zugriff auf mindestens einen Teil der Programmierdaten aus der nicht-flüchtigen Speichervorrichtung (320a, 320b, 320c, 320d, 400, 420) in einen oder mehrere Lese- und Ladebefehle umfasst,
- die bewirken, dass Daten der in dem ersten Register (110, 110a, 110b, 110c, 110d, 120, 120a, 120b, 120c, 120d, 410, 410a, 410b) gehaltenen Programmierdaten, die nicht in dem Array (130, 130a, 130b) gespeichert sind, aus der nicht-flüchtigen Speichereinrichtung (320a, 320b, 320c, 320d, 400, 420) abgerufen werden.

13. Verfahren nach Anspruch 9,
_ wobei das Verfahren ferner das Übersetzen einer weiteren Anforderung zum Programmieren von Daten in das Array (130, 130a, 130b) des nicht-flüchtigen Speichers in einen oder mehrere andere Programmierbefehle umfasst,
_ die bewirken, dass ein Segment der Programmierdaten in den flüchtigen Speicher des ersten Registers (110, 110a, 110b, 110c, 110d, 120, 120a, 120b, 120c, 120d, 410, 410a, 410b) der nicht-flüchtigen Speichereinrichtung (320a, 320b, 320c, 320d, 400, 420) geladen werden,
_ so dass das eine Segment von Programmierdaten in das Array (130, 130a, 130b) mit den Programmierdaten, die der ersten Anforderung zugeordnet sind, in einem Einzelseiten-Programmiervorgang programmiert werden kann.

14. Verfahren nach Anspruch 9,
_ wobei die nicht-flüchtige Speichervorrichtung (320a, 320b, 320c, 320d, 400, 420) einen Chip mit mehreren Ebenen eines nicht-flüchtigen Speichers umfasst.

15. Verfahren nach Anspruch 9, das ferner Folgendes umfasst:
Laden zweiter Programmierdaten, die in ein anderes Array (130, 130a, 130b) nicht-flüchtiger Speicherzellen der anderen nicht-flüchtigen Speichervorrichtung (320a, 320b, 320c, 320d, 400, 420) zu programmieren sind, in ein drittes Register (110, 110a, 110b, 110c, 110d, 120, 120a, 120b, 120c, 120d, 410, 410a, 410b) der anderen nicht-flüchtigen Speichervorrichtung (320a, 320b, 320c, 320d, 400, 420);
Laden zweiter Lesedaten, die aus dem anderen Array (130, 130a, 130b) nicht-flüchtiger Speicherzellen gelesen wurden, in ein viertes Register (110, 110a, 110b, 110c, 110d, 120, 120a, 120b, 120c, 120d, 410, 410a, 410b) der anderen nicht-flüchtigen Speichervorrichtung (320a, 320b, 320c, 320d, 400, 420); und
Bereitstellen der zweiten Lesedaten aus dem vierten Register (110, 110a, 110b, 110c, 110d, 120, 120a, 120b, 120c, 120d, 410, 410a, 410b) an die Steuerung (310),
- während das dritte Register (110, 110a, 110b, 110c, 110d, 120, 120a, 120b, 120c, 120d, 410, 410a, 410b) die zweiten Programmierdaten hält, die in das andere Array (130, 130a, 130b) von nicht-flüchtigen Speicherzellen zu programmieren sind.

## Revendications

1. Appareil (300) comportant :
un contrôleur (310) ;
un premier dispositif à mémoire non volatile (320a, 320b, 320c, 320d, 400, 420) ; et
un deuxième dispositif à mémoire non volatile (320a, 320b, 320c, 320d, 400, 420),
le premier dispositif à mémoire non volatile (320a, 320b, 320c, 320d, 400, 420) comportant :
un premier réseau (130, 130a, 130b) de cellules de mémoire non volatile qui est configuré pour stocker des données ;
un premier registre (110, 110a, 110b, 110c, 110d, 120, 120a, 120b, 120c, 120d, 410, 410a, 410b) comportant sur celui-ci une mémoire volatile ; et
un deuxième registre (110, 110a, 110b, 110c, 110d, 120, 120a, 120b, 120c, 120d, 410, 410a, 410b) comportant sur celui-ci une mémoire volatile, dans lequel le premier registre (110, 110a, 110b, 110c, 110d, 120, 120a, 120b, 120c, 120d, 410, 410a, 410b) comporte l'un parmi un registre de mémoire cache ou un registre de données, et dans lequel le deuxième registre (110, 110a, 110b, 110c, 110d, 120, 120a, 120b, 120c, 120d, 410, 410a, 410b) comporte l'autre parmi le registre de mémoire cache ou le registre de données ;
le deuxième dispositif à mémoire non volatile (320a, 320b, 320c, 320d, 400, 420) comportant :
un deuxième réseau (130, 130a, 130b) de cellules de mémoire non volatile qui est configuré pour stocker des données ;
un troisième registre (110, 110a, 110b, 110c, 110d, 120, 120a, 120b, 120c, 120d, 410, 410a, 410b) comportant une mémoire volatile ; et
un quatrième registre (110, 110a, 110b, 110c, 110d, 120, 120a, 120b, 120c, 120d, 410, 410a, 410b) comportant une mémoire volatile, dans lequel le troisième registre (110, 110a, 110b, 110c, 110d, 120, 120a, 120b, 120c, 120d, 410, 410a, 410b) comporte l'un parmi un registre de mémoire cache ou un registre de données, et dans lequel le quatrième registre (110, 110a, 110b, 110c, 110d, 120, 120a, 120b, 120c, 120d, 410, 410a, 410b) comporte l'autre parmi le registre de mémoire cache ou le registre de données,
dans lequel le contrôleur (310) est configuré pour générer des commandes servant à des fins de maintien de données dans une mémoire cache virtuelle répartie mise en œuvre par les registres de données du premier dispositif à mémoire non volatile (320a, 320b, 320c, 320d, 400, 420) et du deuxième dispositif à mémoire non volatile (320a, 320b, 320c, 320d, 400, 420), dans lequel le contrôleur est configuré pour générer des commandes pour amener la première mémoire non volatile (320a, 320b, 320c, 320d, 400, 420) à :
charger des données de programmation destinées à être programmées sur le premier réseau (130, 130a, 130b) de cellules de mémoire non volatile dans le premier registre (110, 110a, 110b, 110c, 110d, 120, 120a, 120b, 120c, 120d, 410, 410a, 410b) ;
charger des données de lecture lues en provenance du premier réseau (130, 130a, 130b) de cellules de mémoire non volatile dans le deuxième registre (110, 110a, 110b, 110c, 110d, 120, 120a, 120b, 120c, 120d, 410, 410a, 410b) ;
fournir les données de lecture en provenance du deuxième registre (110, 110a, 110b, 110c, 110d, 120, 120a, 120b, 120c, 120d, 410, 410a, 410b) au contrôleur (310) alors que le premier registre (110, 110a, 110b, 110c, 110d, 120, 120a, 120b, 120c, 120d, 410, 410a, 410b) retient les données de programmation destinées à être programmées sur le premier réseau (130, 130a, 130b) de cellules de mémoire non volatile ;
déplacer les données de programmation destinées à être programmées pour aller du premier registre (110, 110a, 110b, 110c, 110d, 120, 120a, 120b, 120c, 120d, 410, 410a, 410b) au deuxième registre (110, 110a, 110b, 110c, 110d, 120, 120a, 120b, 120c, 120d, 410, 410a, 410b) en réponse à la détermination comme quoi les données de programmation font moins d'une page de données et charger ultérieurement des deuxièmes données de lecture en provenance du premier réseau (130, 130a, 130b) de cellules de mémoire non volatile dans le premier registre (110, 110a, 110b, 110c, 110d, 120, 120a, 120b, 120c, 120d, 410, 410a, 410b) ;
fournir les deuxièmes données de lecture dans le premier registre (110, 110a, 110b, 110c, 110d, 120, 120a, 120b, 120c, 120d, 410, 410a, 410b) au contrôleur (310) ; et
déplacer les données de programmation destinées à être programmées pour aller du deuxième registre (110, 110a, 110b, 110c, 110d, 120, 120a, 120b, 120c, 120d, 410, 410a, 410b) au premier registre (110, 110a, 110b, 110c, 110d, 120, 120a, 120b, 120c, 120d, 410, 410a, 410b).

2. Appareil (300) selon la revendication 1, dans lequel le premier dispositif à mémoire non volatile (320a, 320b, 320c, 320d, 400, 420) comporte un dispositif à mémoire flash NON-ET.

3. Appareil selon la revendication 1, dans lequel le contrôleur (310) est configuré pour générer des commandes pour amener la deuxième mémoire non volatile (320a, 320b, 320c, 320d, 400, 420) à :
charger des deuxièmes données de programmation destinées à être programmées sur le deuxième réseau (130, 130a, 130b) de cellules de mémoire non volatile dans le troisième registre (110, 110a, 110b, 110c, 110d, 120, 120a, 120b, 120c, 120d, 410, 410a, 410b) ;
charger des deuxièmes données de lecture lues en provenance du deuxième réseau (130, 130a, 130b) de cellules de mémoire non volatile dans le quatrième registre (110, 110a, 110b, 110c, 110d, 120, 120a, 120b, 120c, 120d, 410, 410a, 410b) ; et
fournir les deuxièmes données de lecture en provenance du quatrième registre (110, 110a, 110b, 110c, 110d, 120, 120a, 120b, 120c, 120d, 410, 410a, 410b) au contrôleur (310) alors que le troisième registre (110, 110a, 110b, 110c, 110d, 120, 120a, 120b, 120c, 120d, 410, 410a, 410b) retient les deuxièmes données de programmation destinées à être programmées sur le deuxième réseau (130, 130a, 130b) de cellules de mémoire non volatile.

4. Appareil (300) selon la revendication 1, dans lequel le contrôleur (310) est configuré pour générer des commandes pour amener la deuxième mémoire non volatile à :
charger des deuxièmes données de programmation destinées à être programmées sur le deuxième réseau (130, 130a, 130b) de mémoire non volatile dans le troisième registre (110, 110a, 110b, 110c, 110d, 120, 120a, 120b, 120c, 120d, 410, 410a, 410b) ;
renvoyer les deuxièmes données de programmation destinées à être programmées qui sont stockées dans le troisième registre (110, 110a, 110b, 110c, 110d, 120, 120a, 120b, 120c, 120d, 410, 410a, 410b) au contrôleur (310) avant que les données destinées à être programmées ne soient programmées sur le deuxième réseau (130, 130a, 130b) de cellules de mémoire non volatile.

5. Appareil (300) selon la revendication 1, dans lequel le contrôleur (310) est configuré pour générer des commandes pour amener la première mémoire non volatile (320a, 320b, 320c, 320d, 400, 420) à charger les données de programmation destinées à être programmées sur le premier réseau (130, 130a, 130b) de cellules de mémoire non volatile dans le premier registre (110, 110a, 110b, 110c, 110d, 120, 120a, 120b, 120c, 120d, 410, 410a, 410b) sans utiliser le deuxième registre (110, 110a, 110b, 110c, 110d, 120, 120a, 120b, 120c, 120d, 410, 410a, 410b).

6. Appareil (300) selon la revendication 1, dans lequel le contrôleur (310) est configuré pour générer une ou plusieurs commandes pour amener le premier dispositif à mémoire non volatile (320a, 320b, 320c, 320d, 400, 420) à déplacer les données de programmation destinées à être programmées qui sont retenues dans le premier registre (110, 110a, 110b, 110c, 110d, 120, 120a, 120b, 120c, 120d, 410, 410a, 410b) jusque dans le deuxième registre (110, 110a, 110b, 110c, 110d, 120, 120a, 120b, 120c, 120d, 410, 410a, 410b), et pour ultérieurement charger des deuxièmes données de lecture en provenance du premier réseau (130, 130a, 130b) jusque dans le premier registre (110, 110a, 110b, 110c, 110d, 120, 120a, 120b, 120c, 120d, 410, 410a, 410b), fournir les deuxièmes données de lecture en provenance du premier réseau (130, 130a, 130b) dans le deuxième registre (110, 110a, 110b, 110c, 110d, 120, 120a, 120b, 120c, 120d, 410, 410a, 410b) au contrôleur (310), et déplacer les données de programmation destinées à être programmées pour aller du deuxième registre (110, 110a, 110b, 110c, 110d, 120, 120a, 120b, 120c, 120d, 410, 410a, 410b) au premier registre (110, 110a, 110b, 110c, 110d, 120, 120a, 120b, 120c, 120d, 410, 410a, 410b).

7. Appareil (300) selon la revendication 1, dans lequel le contrôleur (310) est configuré pour fournir des commandes à la premier mémoire non volatile (320a, 320b, 320c, 320d, 400, 420) de telle sorte que des registres séparés (110, 110a, 110b, 110c, 110d, 120, 120a, 120b, 120c, 120d, 410, 410a, 410b) sont utilisés pour retenir les données lues en provenance du premier réseau (130, 130a, 130b) et les données destinées à être programmées sur le premier réseau (130, 130a, 130b).

8. Appareil (300) selon la revendication 1, dans lequel le contrôleur (310) est configuré pour récupérer des données en provenance du premier registre (110, 110a, 110b, 110c, 110d, 120, 120a, 120b, 120c, 120d, 410, 410a, 410b) avant que les données récupérées ne soient programmées sur le premier réseau (130, 130a, 130b) de cellules de mémoire non volatile.

9. Procédé mis en œuvre de manière électronique servant à traduire des demandes d'accès à un dispositif à mémoire non volatile (320a, 320b, 320c, 320d, 400, 420), le procédé comportant les étapes consistant à :
tel qu'il est mis en œuvre par un contrôleur (310) d'un dispositif à mémoire non volatile (320a, 320b, 320c, 320d, 400, 420) qui est configuré pour générer des commandes servant à des fins de maintien de données dans une mémoire cache virtuelle répartie mise en œuvre par des registres de données du dispositif à mémoire non volatile (320a, 320b, 320c, 320d, 400, 420) et un autre dispositif à mémoire non volatile (320a, 320b, 320c, 320d, 400, 420) ;
traduire une première demande de programmation de données de programmation sur un premier réseau (130, 130a, 130b) de cellules de mémoire non volatile du dispositif à mémoire non volatile (320a, 320b, 320c, 320d, 400, 420) en une ou plusieurs commandes de programmation qui amènent les données de programmation à être chargées dans une mémoire volatile d'un premier registre (110, 110a, 110b, 110c, 110d, 120, 120a, 120b, 120c, 120d, 410, 410a, 410b) du dispositif à mémoire non volatile (320a, 320b, 320c, 320d, 400, 420) et ultérieurement programmées sur le réseau (130, 130a, 130b) de cellules de mémoire non volatile ;
recevoir une deuxième demande d'accès à des données de lecture en provenance du dispositif à mémoire non volatile (320a, 320b, 320c, 320d, 400, 420) avant la programmation des données associées à la première demande qui sont programmées sur le premier réseau (130, 130a, 130b) de cellules de mémoire non volatile ;
traduire la deuxième demande d'accès aux données de lecture en provenance du dispositif à mémoire non volatile (320a, 320b, 320c, 320d, 400, 420) en une ou plusieurs commandes de lecture qui amènent le dispositif à mémoire non volatile (320a, 320b, 320c, 320d, 400, 420) à accéder aux données de lecture en provenance du réseau (130, 130a, 130b) de cellules de mémoire non volatile et charger les données de lecture dans la mémoire volatile d'un deuxième registre (110, 110a, 110b, 110c, 110d, 120, 120a, 120b, 120c, 120d, 410, 410a, 410b) du dispositif à mémoire non volatile (320a, 320b, 320c, 320d, 400, 420) de telle sorte que le premier registre (110, 110a, 110b, 110c, 110d, 120, 120a, 120b, 120c, 120d, 410, 410a, 410b) peut retenir de manière simultanée au moins une partie des données de programmation et les données de lecture associées à la deuxième demande peuvent être lues en provenance du dispositif à mémoire non volatile (320a, 320b, 320c, 320d, 400, 420) avant que les données de programmation associées à la première demande ne soient programmées sur le réseau (130, 130a, 130b) de cellules de mémoire non volatile ;
générer une ou plusieurs commandes pour amener le dispositif à mémoire non volatile (320a, 320b, 320c, 320d, 400, 420) à déplacer les données de programmation destinées à être programmées pour aller du premier registre (110, 110a, 110b, 110c, 110d, 120, 120a, 120b, 120c, 120d, 410, 410a, 410b) au deuxième registre (110, 110a, 110b, 110c, 110d, 120, 120a, 120b, 120c, 120d, 410, 410a, 410b) en réponse à la détermination comme quoi les données de programmation font moins d'une page de données et charger ultérieurement des deuxièmes données de lecture en provenance du réseau (130, 130a, 130b) de cellules de mémoire non volatile dans le premier registre (110, 110a, 110b, 110c, 110d, 120, 120a, 120b, 120c, 120d, 410, 410a, 410b), fournir les deuxièmes données de lecture dans le premier registre (110, 110a, 110b, 110c, 110d, 120, 120a, 120b, 120c, 120d, 410, 410a, 410b) au contrôleur (310), et déplacer les données de programmation destinées à être programmées pour aller du deuxième registre (110, 110a, 110b, 110c, 110d, 120, 120a, 120b, 120c, 120d, 410, 410a, 410b) au premier registre (110, 110a, 110b, 110c, 110d, 120, 120a, 120b, 120c, 120d, 410, 410a, 410b) .

10. Procédé selon la revendication 9, dans lequel le premier registre (110, 110a, 110b, 110c, 110d, 120, 120a, 120b, 120c, 120d, 410, 410a, 410b) est un registre de données et le deuxième registre (110, 110a, 110b, 110c, 110d, 120, 120a, 120b, 120c, 120d, 410, 410a, 410b) est un registre de mémoire cache.

11. Procédé selon la revendication 9, dans lequel le premier registre (110, 110a, 110b, 110c, 110d, 120, 120a, 120b, 120c, 120d, 410, 410a, 410b) est un registre de mémoire cache et le deuxième registre (110, 110a, 110b, 110c, 110d, 120, 120a, 120b, 120c, 120d, 410, 410a, 410b) est un registre de données.

12. Procédé selon la revendication 9, dans lequel le procédé comporte par ailleurs l'étape consistant à traduire une troisième demande d'accès à au moins une partie des données de programmation en provenance du dispositif à mémoire non volatile (320a, 320b, 320c, 320d, 400, 420) en une ou plusieurs commandes de chargement en cours de lecture qui amènent les données des données de programmation retenues dans le premier registre (110, 110a, 110b, 110c, 110d, 120, 120a, 120b, 120c, 120d, 410, 410a, 410b) qui ne sont pas stockées dans le réseau (130, 130a, 130b) à être récupérées en provenance du dispositif à mémoire non volatile (320a, 320b, 320c, 320d, 400, 420).

13. Procédé selon la revendication 9, dans lequel le procédé comporte par ailleurs l'étape consistant à traduire une autre demande de programmation de données sur le réseau (130, 130a, 130b) de la mémoire non volatile en une ou plusieurs autres commandes de programmation qui amènent un segment de données de programmation à être chargé dans la mémoire volatile du premier registre (110, 110a, 110b, 110c, 110d, 120, 120a, 120b, 120c, 120d, 410, 410a, 410b) du dispositif à mémoire non volatile (320a, 320b, 320c, 320d, 400, 420) de telle sorte que ledit un segment de données de programmation peut être programmé sur le réseau (130, 130a, 130b) avec les données de programmation associées à la première demande en une opération de programme monopage.

14. Procédé selon la revendication 9, dans lequel le dispositif à mémoire non volatile (320a, 320b, 320c, 320d, 400, 420) comporte une matrice ayant de multiples plans de mémoire non volatile.

15. Procédé selon la revendication 9, comportant par ailleurs les étapes consistant à :
charger des deuxièmes données de programmation destinées à être programmées sur un autre réseau (130, 130a, 130b) de cellules de mémoire non volatile d'un autre dispositif à mémoire non volatile (320a, 320b, 320c, 320d, 400, 420) dans un troisième registre (110, 110a, 110b, 110c, 110d, 120, 120a, 120b, 120c, 120d, 410, 410a, 410b) d'un autre dispositif à mémoire non volatile (320a, 320b, 320c, 320d, 400, 420) ;
charger des deuxièmes données de lecture lues en provenance dudit un autre réseau (130, 130a, 130b) de cellules de mémoire non volatile dans un quatrième registre (110, 110a, 110b, 110c, 110d, 120, 120a, 120b, 120c, 120d, 410, 410a, 410b) dudit un autre dispositif à mémoire non volatile (320a, 320b, 320c, 320d, 400, 420) ; et
fournir les deuxièmes données de lecture en provenance du quatrième registre (110, 110a, 110b, 110c, 110d, 120, 120a, 120b, 120c, 120d, 410, 410a, 410b) au contrôleur (310) alors que le troisième registre (110, 110a, 110b, 110c, 110d, 120, 120a, 120b, 120c, 120d, 410, 410a, 410b) retient les deuxièmes données de programmation destinées à être programmées sur ledit un autre réseau (130, 130a, 130b) de cellules de mémoire non volatile.
